# EUROPEAN PATENT APPLICATION

(11) **EP 1 850 649 A1**
(43) Date of publication of application: **31.10.2007**
(21) Application number: 06713795.0
(22) Date of filing: 15.02.2006
(51) Int. Cl.: H05K 9/00, B32B 7/02, B32B 15/08, G09F 9/00, H01B 5/14

(54) **LIGHT TRANSMITTING CONDUCTIVE FILM, LIGHT TRANSMITTING ELECTROMAGNETIC SHIELD FILM, OPTICAL FILTER AND METHOD FOR MANUFACTURING DISPLAY FILTER**

(30) Priority: 15.02.2005 JP 2005038194; 22.02.2005 JP 2005046247
(71) Applicant: Fujifilm Corporation, Minato-ku Tokyo 106-0031 (JP); Mitsui Chemicals, Inc., Tokyo 105-7117 (JP)
(72) Inventor: OKAZAKI, Kentaro, Kanagawa (JP); MORIMOTO, Akimitsu, Sodegaura-shi Chiba (JP); OKAMURA, Tomoyuki, Sodegaura-shi Chiba (JP); KITAGAWA, Toshihisa, Sodegaura-shi Chiba (JP); MOROHASHI, Makoto, Sodegaura-shi Chiba (JP); ITO, Tomoaki, Sodegaura-shi Chiba (JP); MINAMI, Hiromi, Sodegaura-shi Chiba (JP)
(74) Representative: HOFFMANN EITLE
(86) International application number: PCT/JP2006/302654
(87) International publication number: WO 2006/088059

(57) **Abstract**

A light transmitting conductive film formed by patterning a conductive metal part and a visible light transmitting part on a transparent support, wherein the conductive metal part is made up of mesh-forming thin lines of from 1 µm to 40 µm in size and the mesh pattern continues for 3 m or longer. A method of producing a display filter wherein the end sections of at least two sides facing each other are in a mesh shape, which comprises using an electromagnetic wave shielding material (C), wherein a conductive layer (B) having the conductive parts being in the mesh shape of the geometric pattern is formed on one face of a polymer film (A) continuously in the machine direction of the polymer film (A), and cutting the mesh-like parts.

## Description

### Technical Field

This invention relates to a light transmitting conductive film. In particular, it relates to an electromagnetic wave shielding material which is capable of shielding electromagnetic wave generated from the front face of a display such as a cathodic ray tube (CRT), a plasma display panel (PDP), a liquid crystal display, an electroluminescence (EL) display or a field emission display (FED), a microwave oven, an electronic device, a printed line board and so on and has a light transmittance, and a method of producing the same. The invention further relates to a method of producing a display filter and a display filter obtained thereby and an electromagnetic wave shielding material to be used therein. More specifically speaking, it relates to a method of producing a display filter comprising an electromagnetic wave shielding material capable of blocking electromagnetic wave generated from a plasma display panel, a display filter obtained thereby and an electromagnetic wave shielding material to be used therein.

### Background Art

With the recent increasing use of various electrical facilities and electronic devices, there arises a rapid increase in electromagnetic interference (EMI). It is pointed out that EMI not only causes mechanical errors and disturbances in electrical devices but also exerts adverse effects on the health of workers operating these devices. Thus, it has been required to control the electromagnetic intensity generated from electrical/electronic devices not to exceed a standard or regulation level.

As a countermeasure against the above-described EMI, it is needed to shield electromagnetic wave, which can be self-evidently established by using the characteristics of a metal of not allowing electromagnetic transmission. Thus, there have been adopted, for example, a method of using a housing made of a metal or a highly conductive material, a method of inserting a metal plate between circuit baseboards and a method of coating a cable with a metal foil. However, a display of a CRT, a PDP or the like should be transparent, since an operator should recognize characters and so on indicated on the screen. However, the front face of a display frequently becomes opaque in each of the methods as cited above, which makes these methods unsuitable as an electromagnetic wave shielding method.

Compared with a CRT, etc., a PDP generates a particularly large amount of electromagnetic wave. Therefore, it is required that a PDP has stronger electromagnetic wave shielding properties. Electromagnetic wave shielding properties can be briefly expressed in surface resistivity. A light transmitting electromagnetic wave shielding material for CRT should have a surface resistivity of about 300 Ω/sq or less, while a light transmitting electromagnetic wave shielding material for PDP should have a surface resistivity of about 2.5 Ω/sq or less. Furthermore, a light transmitting electromagnetic wave shielding material for plasma TV for consumer use should have an extremely high conductivity, i.e., a surface resistivity of about 1.5 Ω/sq or less, preferably 0.1 Ω/sq or less.

Concerning transparency, a light transmitting electromagnetic wave shielding material for CRT should have a transparency of about 70% or more, while a light transmitting electromagnetic wave shielding material for PDP should have a still higher transparency of 80% or more.

To overcome the problems as discussed above, there have been proposed various materials and methods for achieving both of favorable electromagnetic wave shielding properties and high transparency with the use of a metal mesh having apertures, as will be described herein below.

### (1) Conductive fiber

For example, JP-A-5-327274 (Patent Document 1) discloses an electromagnetic wave shielding material made of conductive fibers. However, this shielding material suffers from a problem that it has a broad mesh line width and, therefore, makes the screen dark when employed in shielding a display screen. As a result, characters indicated on the display becomes hardly visible.

### (2) Mesh obtained by electroless plating process

There has been proposed a method which comprises printing a lattice pattern by using an electroless plating catalyst and then conducting electroless plating (see, for example, JP-A-11-170420 (Patent Document 2) and JP-A-05-283889 (Patent Document 3)). In this case, however, the printed catalyst has a broad line width of about 60 µm, which makes it unsuitable for a display with a need for a relatively narrow line width and a precise pattern.

Moreover, there has been proposed a method which comprises coating a photoresist containing an electroless plating catalyst, exposing and developing the same to form an electroless plating catalyst pattern and then conducting electroless plating (see, for example, JP-A-11-170421 (Patent Document 4)). However, a conductive film has a visible light transmittance of 72% and, therefore, only an insufficient transparency can be obtained thereby. Moreover, this method suffers from a problem in the production cost, i.e., highly expensive palladium should be employed as the electroless plating catalyst for removing most of the exposed part after the exposure.

### (3) Mesh obtained by etching process using photolithographic technique

There has been proposed a method wherein a thin metal mesh film is formed on a transparent substrate by etching process using a photolithographic technique (see, for example, JP-A-2003-46293 (Patent Document 5), JP-A-2003-23290 (Patent Document 6), JP-A-5-16281 (Patent Document 7), JP-A-10-338848 (Patent Document 8), etc.). Because of enabling fine processing, this method is advantageous in forming a mesh having a high aperture ratio (a high transmittance) and being capable of shielding even strong electromagnetic release. On the other hand, it suffers from a problem that the production process is troublesome and complicated and, therefore, costs high. Further, it is known that because of using the etching procedure, the lattice pattern has a problem that the intersecting points have broader line width than straight lines. Furthermore, it has been pointed out that this method suffers from the problem of moire that should be overcome.

### (4) Mesh obtained by copper-plating on conductive metallic silver and development sliver using silver halide

There has been proposed a method of forming a conductive mesh with the use of conductive metallic silver obtained by developing a silver halide or a method of forming a conductive mesh by plating a mesh-like developed silver obtained by developing a silver halide with metallic copper (see, for example, JP-A-2004-221564 (Patent Document 9)).

Displays have been widely used particularly for personal computers, monitors and so on. Also, there is a tendency toward thin and large-sized displays. As a large and thin display, a plasma display panel has attracted public attention. Due to the structure and operation mechanism thereof, however, plasma display panel suffers from serious leakage of electromagnetic wave and generates near infrared rays. According to Electrical Appliance and Material Safety Law, electromagnetic wave generation should be regulated not to exceed a standard level. Since near infrared rays affect peripheral devices and cause mechanical errors, rays within the near infrared region (800 to 1000 nm) should be cut to a level causing no problem in practice.

To shield electromagnetic wave, it is required cover the display surface with a highly conductive substance. Such a highly conductive substance to be used in covering (i.e., an electromagnetic wave shielding material) should be transparent so as not to seriously damage the display indication. As one of electromagnetic wave shielding materials fulfilling these requirements, it has been a practice to use electromagnetic wave shielding films produced by forming a transparent multilayer film made of an oxide, a metal, etc. on a transparent base by, for example, sputtering. However, these electromagnetic wave shielding films are still insufficient in conductivity at present. Therefore, they are usable as an electromagnetic wave shielding material exclusively in the case with a need for only low electromagnetic wave shielding properties. As another electromagnetic wave shielding material, there have been employed conductive mesh films produced by forming a mesh-patterned metal layer on a base made of a polymer film. In this method, a high light transmittance can be established by forming the mesh pattern by using a microprocessing technique such as photolithography. Since the mesh pattern is formed with the use of a metal, moreover, a higher electromagnetic wave shielding ability can be established than in the case of using a transparent multilayer film.

When electromagnetic wave is absorbed by a conductive substance, an electrical charge is generated on the conductive substance. The electrical charge thus generated induces the oscillation of electromagnetic wave again with the use of the conductive substance as an antenna. Unless the thus generated electrical charge is quickly made escape through an earthing wire, there arises a risk of the leakage of the electromagnetic wave. Thus, the conductive layer of the display filter should be electrically connected to the inside of the display body. A display filter having these functions is reported by, for example, JP-A-2002-323861 (Patent Document 10).

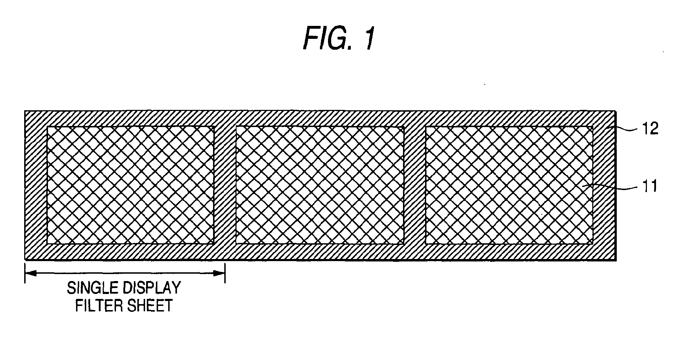

In a conductive mesh film to be used in a display filter as described above, it is necessary to conduct patterning the metal layer of each single display filter by using a mask in a size fitting the indication part of the display. Fig. 1 shows an example of conductive mesh film having been employed hitherto. In bonding a conductive mesh film as shown in Fig. 1 to a glass plate, the mesh-patterned part and the non-mesh part should be positioned in accordance with the specification of the display. Thus, it takes a longer time for bonding and there arises an increase in positioning loss, which results in a lowering in the production efficiency. That is to say, a conductive mesh film of this type suffers from a serious problem in production cost. In the conductive mesh film as shown in Fig. 1, furthermore, the mesh part serving as the indication part and the non-mesh part serving as the non-indication part for connecting to the display body are both fixed in size. As a result, there arises another problem that such a conductive mesh film of a certain specification can be hardly applicable to various filters.
Patent Document 1: JP-A-5-327274
Patent Document 2: JP-A-11-170420
Patent Document 3: JP-A-5-283889
Patent Document 4: JP-A-11-170421
Patent Document 5: JP-A-2003-46293
Patent Document 6: JP-A-2003-23290
Patent Document 7: JP-A-5-16281
Patent Document 8: JP-A-10-338848
Patent Document 9: JP-A-2004-207001
Patent Document 10: JP-A-2002-323861

### Disclosure of the Invention

### Problems that the Invention is to Solve

It is known that the shielding ability of an EMI shielding material is improved by earthing the conductive part. A mesh suffering from a line breakage frequently has an area that cannot be earthed. Therefore, an area to be used as an EMI shielding material should be prevented from line breakage. According to the existing mesh-forming methods excluding the fiber system as discussed above, on the other hand, it is only possible to produce a mesh being free from line breakage in a certain area. This is because, when a mesh pattern is formed by the electroless copper plating process, the plating catalyst nucleus is patterned by the printing system as in screen printing and, therefore, the mesh undergoes breakage in a screen or depressed surface unit. In the photolithography, a mesh undergoes breakage in an exposure mask unit.

Although JP-A-2004-207001 discloses using an image setter of the internal drum system in exposure, a mesh undergoes breakage in a length shorter than the inner periphery of the drum in this internal drum system.

To overcome these problems, use is made of, for example, in producing a conductive mesh film for PDP, a method comprising positioning a mesh breakage-free part of a shielding material with a PDP module or an optical filter material which is called a front face panel or a window material and has a glass or the like as a substrate. In this method, there arises a greater loss in the shielding material. Even in the case of using a rolled shielding material in a long sheet type for elevating the productivity, it takes a longer time for positioning and thus the production speed cannot be sufficiently elevated.

The present invention has been made under these circumstances. Namely, a first object of the invention is to provide a method whereby a light transmitting conductive film, which has both of favorable EMI shielding properties and a high transparency at the same time and is free from moire, and whereby a thin line pattern can be easily formed inexpensively on a large scale. Another object of the invention is to provide an electromagnetic wave shielding material having a continuous mesh pattern formed thereon so as to reduce a loss in the shielding material and elevate the productivity.

Taking the known techniques as described above into consideration, another object of the invention is to provide a method of producing a display filter at a high production efficiency and a low cost.

### Means for Solving the Problems

From the viewpoint of achieving both of favorable EMI shielding properties and a high transparency at the same, the inventors conducted intensive studies. As a result, they have found out that the first object as described above can be effectively achieved by the following light transmitting electromagnetic wave shielding film, thereby completing the present invention. As the results of the subsequent studies aiming at achieving the second object as described above, the inventors have further found out that by fabricating a display filter by using an electromagnetic wave shielding material, in which a mesh-like conductive layer is continuously formed on one face of a polymer film in the machine direction, and cutting the mesh-like parts, the single electromagnetic wave shielding material is applicable to filters with various specifications and an additional procedure and a loss in the material caused by the positioning in the indication part can be prevented, thereby elevating the production efficiency. The present invention has been thus completed.

Accordingly, the constitution of the present invention is as follows.
1. A light transmitting conductive film formed by patterning a conductive metal part and a visible light transmitting part on a transparent support,
   wherein the conductive metal part is made up of mesh-forming thin lines of from 1 µm to 40 µm in size and the mesh pattern continues for 3 m or longer.
2. A light transmitting conductive film formed by patterning a developed silver part and a visible light transmitting part on a transparent support, and making the developed silver part to carry a conductive metal thereon to form a conductive metal part,
   wherein the conductive metal part is in a mesh shape made up of thin lines of from 1 µm to 30 µm in size and the mesh pattern continues for 3 m or longer.
3. The light transmitting conductive film as described in item 1 or 2 above,
   wherein the transparent support is a film which has a flexibility and is 2 cm or more in width, 3 m or more in length and 200 µm or less in thickness.
4. The light transmitting conductive film as described in any of items 1 to 3 above,
   wherein the mesh pattern is a pattern made up of straight thin lines, which are being arranged substantially in parallel, intersecting with each other.
5. The light transmitting conductive film as described in any of items 1 to 4 above,
   wherein the patterning is conducted by scan-exposing the transparent support with a laser light beam while transporting the transparent support on a curved exposure stage.
6. The light transmitting conductive film as described in item 5 above,
   wherein a main scanning direction of the light beam is perpendicular to a support transport direction.
7. The light transmitting conductive film as described in item 5 or 6 above,
   wherein a light intensity of the light beam has two or more values including state of being substantially zero.
8. The light transmitting conductive film as described in any of items 1 to 4 above,
   wherein the patterning is conducted by using an exposure head intersecting with a support transport direction, and
   the exposure head comprises: an irradiation unit for emitting a light beam; a spatial modulation element for modulating the light beam emitted by the irradiation unit, including a plurality of pixel portions which change light modulation states in accordance with respective control signals, the pixel portions being arranged in a two-dimensional pattern on the support; a controller for controlling respective pixel portions, which are in a smaller number than the sum of the pixel portions arranged on the support, in accordance with the control signals formed on the basis of exposure data; and an optical system for focusing images of the light beam having been modulated by the respective pixel portions onto an exposure surface.
9. The light transmitting conductive film as described in any of items 5 to 8 above,
   wherein the scanning is conducted while inclining the light beam at an angle of 30° to 60° to the transport direction.
10. The light transmitting conductive film as described in item 9 above,
   wherein a light intensity of the light beam has only one value in the course of the patterning.
11. The light transmitting conductive film as described in any of items 5 to 10 above,
   wherein a wavelength of the light beam is 420 nm or less.
12. The light transmitting conductive film as described in any of items 5 to 10 above,
   wherein a wavelength of the light beam is 600 nm or more.
13. The light transmitting conductive film as described in any of items 5 to 11 above,
   wherein an energy of the light beam is 1 mJ/cm² or less.
14. The light transmitting conductive film as described in any of items 2 to 13 above,
   wherein the developed silver part is formed by developing a silver halide.
15. The light transmitting conductive film as described in any of items 1 and 3 to 13 above,
   wherein the conductive metal part is formed by etching a copper foil.
16. A light transmitting electromagnetic wave shielding film, which comprises the light transmitting conductive film as described in any of items 1 to 15 above.
17. The light transmitting electromagnetic wave shielding film as described in item 16 above, which has an adhesive layer.
18. The light transmitting electromagnetic wave shielding film as described in item 16 or 17 above, which has a peelable protective film.
19. The light transmitting electromagnetic wave shielding film as described in any of items 16 to 18 above,
   wherein a part having a black color amounts to 20% or more of a total surface area of the conductive patterned face.
20. The light transmitting electromagnetic wave shielding film as described in any of items 16 to 19 above, which has a functional transparent layer having one or more functions selected from the group consisting of infrared ray-shielding properties, hard coating properties, antireflective properties, antiglare properties, antistatic properties, antifouling properties, ultraviolet ray protection properties, gas barrier properties and display panel-breakage prevention properties.
21. The light transmitting electromagnetic wave shielding film as described in any of items 16 to 20 above, which has infrared ray-shielding properties.
22. An optical filter, which has the light transmitting electromagnetic wave shielding film as described in any of items 16 to 21 above.
23. A display filter, which uses the light transmitting conductive film as described in any of items 1 to 15 above.
24. The display filter as described in item 23 above,
   wherein end sections of at least two sides facing each other serve as conductive parts of a geometric pattern.
25. The display filter as described in item 24 above,
   wherein an electrode is formed by using a black conductive coating.
26. A method of producing a display filter by using the light transmitting conductive film as described in any of items 1 to 15 above, the method comprises the step of bonding to a film having a sticky material layer having a width narrower than the light transmitting conductive film.
27. The method of producing a display filter as described in item 26 above, which comprises the step of bonding the light transmitting conductive film having been bonded to the film having a sticky material layer to a substrate having a width wider than the light transmitting conductive film.
28. The method of producing a display filter as described in item 26 or 27 above, which comprises the step of bonding the light transmitting conductive film having been bonded to the film having a sticky material layer to a substrate,
   wherein the bonding is conducted so that a center in the width direction of the light transmitting conductive film agrees with a center in the width direction of the substrate.
29. The method of producing a display filter as described in item 27 or 28 above,
   wherein a functional film is bonded to the opposite side of the substrate to the light transmitting conductive film.
30. The method of producing a display filter as described in item 29 above,
   wherein the functional film has a width narrower than the light transmitting conductive film.
31. A method of producing a light transmitting conductive film, which comprises scan-exposing a transparent support with a laser beam while transporting the transparent support on a curved exposure stage; and thus
   forming a mesh pattern comprising: a conductive metal part made up of mesh-forming thin lines of from 1 µm to 40 µm in size; and a visible light transmitting part, and continuing for 3 m or longer.
32. The method of producing a light transmitting conductive film as described in item 31 above,
   wherein the conductive metal part is a developed silver part.
33. The method of producing a light transmitting conductive film as described in item 32 above,
   wherein the conductive metal part is formed by making the developed silver part to carry a conductive metal thereon.
34. The method of producing a light transmitting conductive film as described in item 32 or 33 above,
   wherein the developed silver part is formed by developing a silver halide.
35. The method of producing a light transmitting conductive film as described in any of items 31 to 34 above,
   wherein the conductive metal part is formed by etching a copper foil.
36. The method of producing a light transmitting conductive film as described in any of items 31 to 35 above,
   wherein the exposure is conducted by using an exposure head a main scanning direction of the light beam of which intersects with a support transport direction.
37. The method of producing a light transmitting conductive film as described in any of items 31 to 36 above,
   wherein scanning is conducted while inclining the light beam at an angle of 30° to 60° to a transport direction.
38. The method of producing a light transmitting conductive film as described in any of items 31 to 37 above,
   wherein a light intensity of the light beam has only one value in the course of the patterning.
39. The method of producing a light transmitting conductive film as described in any of items 31 to 38 above,
   wherein a wavelength of the light beam is 420 nm or less.
40. The method of producing a light transmitting conductive film as described in any of items 31 to 39 above,
   wherein a wavelength of the light beam is 600 nm or more.
41. The method of producing a light transmitting conductive film as described in any of items 31 to 40 above,
   wherein an energy of the light beam is 1 mJ/cm² or less.
42. A method of producing a display filter, wherein end sections of at least two sides facing each other serve as conductive parts of a geometric pattern, with using an electromagnetic wave shielding material (C) wherein a conductive layer (B) having the conductive parts of the geometric pattern is formed on one face of a polymer film (A),
   wherein the conductive parts of the geometric pattern is continuously formed in a machine direction of the polymer film (A), the conductive parts of the geometric pattern is in a mesh shape having a line width of 1 to 50 µm and intervals of 30 to 500 µm, and a surface resistivity of the conductive layer (B) is 0.01 to 1 Ω/□, and
   wherein the method comprises at least the step of cutting the conductive parts of the geometric pattern.
43. The method of producing a display filter as described in item 42 above,
   wherein the electromagnetic wave shielding material (C) comprises a conductive layer (B) wherein the conductive parts are formed by forming a geometric pattern by using a conductive substance (B1) on one face of the polymer film (A) and attaching a conductive substance (B2) on the geometric pattern.
44. The method of producing a display filter as described in item 42 above,
   wherein the electromagnetic wave shielding material (C) comprises a conductive layer (B) wherein the conductive parts of the geometric pattern are formed by bonding the polymer film (A) to a metal foil (B4) via an adhesive layer (B3) and then processing the metal foil (B4).
45. The method of producing a display filter as described in any of items 42 to 44 above,
   wherein at least one face of the conductive layer (B) has a black or blackish brown color.
46. A display filter, which is obtained by the production method as described in any of items 42 to 45 above.
47. The display filter as described in item 46 above, which is to be used in a plasma display panel.
48. An electromagnetic wave shielding material to be used in producing the display filter as described in any of items 42 to 45 above, which is an electromagnetic wave shielding material (C) wherein a conductive layer (B) having conductive parts of a geometric pattern is formed on one face of a polymer film (A),
   wherein the conductive parts of the geometric pattern is continuously formed in a machine direction of the polymer film (A), the conductive parts of the geometric pattern is in a mesh shape having a line width of 1 to 50 µm and intervals of 30 to 500 µm, and a surface resistivity of the conductive layer (B) is 0.01 to 1 Ω/□.

### Advantage of the Invention

The present invention makes it possible to obtain a method whereby a thin line pattern can be easily formed inexpensively on a large scaled. According to this method, it becomes possible to provide a light transmitting conductive film which has both of favorable EMI shielding properties and a high transparency at the same time, is free from moire and has a continuous mesh pattern that is formed so as to reduce a loss in the shielding material and elevate the productivity.

According to the invention, it is furthermore possible to provide a display filter by using a method which achieves an extremely high production efficiency and yet requires only a low cost.

### Brief Description of the Drawings

[Fig. 1] Fig. 1 presents an example of a plan view of a conductive mesh film produced by a known technique.
[Fig. 2] Fig. 2 is a plan view of an electromagnetic wave shielding material (C) according to the invention, wherein a conductive mesh pattern (B) is formed on the entire face of a polymer film (A), observed from the conductive layer (B) side.
[Fig. 3] Fig. 3 is a plan view of an electromagnetic wave shielding material (C) according to the invention, wherein a mesh pattern of a conductive layer (B) is formed continuously on a polymer film (A) excluding the end sections being in parallel to the mechanical direction of the polymer film (A), observed from the conductive layer (B) side.
[Fig. 4] Fig. 4 is a sectional view showing an example of a display filter (Example 2-1) fabricated in accordance with the invention.
[Fig. 5] Fig. 5 is a sectional view showing an example of a display filter (Example 2-2) fabricated in accordance with the invention.
[Fig. 6] Fig. 6 is a sectional view showing an example of a filter-integrated plasma display panel (Example 2-3) fabricated in accordance with the invention.
[Fig. 7] Fig. 7 is a sectional view showing an example of a display filter (Example 2-4) fabricated in accordance with the invention.

### Description of the Reference Numerals

- 10: Electromagnetic wave shielding material (C)
- 11: Mesh-like part of conductive layer (B)
- 12: Non-mesh part of conductive layer (B)
- 13: Polymer film (A)
- 14: Adhesive layer (B3)
- 20: Transparent sticky material (D1)
- 30: Transparent support (F)
- 40: Transparent sticky material (D2)
- 50: Functional film (E)
- 51: Near infrared absorber-containing layer (E)
- 52: Hard coat layer and antireflective layer having antistatic and antifouling properties
- 53: Polymer film capable of cutting ultraviolet light
- 60: Silver paste electrode
- 70: Plasma display panel

### Best Mode for Carrying Out the Invention

Next, a light transmitting electromagnetic wave shielding film and a method of producing the same, whereby the first object of the present invention can be achieved, will be described in greater detail.

The term "to" inserted between numerical values herein has a meaning including the numerical values presented immediately before and after the same respectively as the lower and upper limits.

Examples of the method whereby the continuous mesh pattern is formed include printing, ink jetting, heat transfer and so on. In the case of printing, a cylindrical printing plate having a seamless continuous pattern formed thereon should be used either in the gravure method, the flexographic method or any other method. It is necessary that thin lines of several to ten-odd µm are arranged at intervals of several hundred µm and each line is connected to its own end after running around the plate. However, it is very difficult to construct such a printing plate and the obtained plate having these thin lines has only insufficient print tolerance.

On the other hand, only an insufficient resolution can be achieved by the ink jetting method or the heat transfer method and, therefore, continuous wires of several µm can be hardly drawn thereby. As the results of intensive studies, the present inventors have found out that thin line drawing with a laser beam is most suitably usable in forming a continuous mesh pattern. In the case of repeatedly drawing precise thin lines over a length of from several hundred to several thousand meters and a width of several meters, however, there arises a problem that the width and pitch would vary due to the vibration during transport or a slight change in the transport speed. To overcome this problem, the inventors conducted further studies. As a result, they have found out that it can be particularly effectively solved by providing a curved exposure stage (more particularly speaking, an exposure roller), which has an even surface in the opposite side across the support of a part wherein a laser beam focuses images on the exposure face, in parallel to the main scanning direction of the laser beam.

It is preferable that the exposure is made of a metal. A material which scarcely undergoes heat deformation and sustains a surface smoothness comparable to a specular surface is preferred. It is also preferable that the diameter of the exposure roller is 5 cm or more but not more than 1 mm, more preferably 10 cm or more but not more than 50 cm.

The light transmitting conductive film according to the invention can be produced by exposing a photosensitive material having an emulsion layer containing a silver halide on a support, then conducting a development process to form a metallic silver part and a light transmitting part respectively in an exposed area and an unexposed area, and applying a physical development and/or a plating process to the metallic silver part thereby making the metallic silver part to carry a conductive metal.

The method of forming the light transmitting conductive film according to the invention involves the following three modes depending on the photosensitive material and the development process employed.
(1) A mode wherein a photosensitive silver halide monochromic photosensitive material free from physical development nucleus is subjected to chemical development or heat development to thereby form a metallic silver part on the photosensitive material.
(2) A mode wherein a photosensitive silver halide monochromic photosensitive material containing physical development nuclei in the silver halide emulsion layer is subjected to dissolution physical development to thereby form a metallic silver part on the photosensitive material.
(3) A mode wherein a photosensitive silver halide monochromic photosensitive material free from physical development nucleus and an image-receiving sheet having a non-photosensitive layer containing a physical development nucleus are overlaid and subjected to diffusion transfer development to thereby form a metallic silver part on the non-photosensitive image-receiving sheet.

In the embodiment (1) of the unified monochromic development type, a light transmitting conductive film such as a light transmitting electromagnetic wave shielding film or an optically transparent conductive film is formed on the photosensitive material. The developed silver thus obtained is chemically developed silver or thermally developed silver in the form of filaments having a large specific surface area. Thus, the subsequent plating is highly active in the course of the physical development.

In the embodiment (2), silver halide grains are dissolved around the physical development nuclei and deposited on the physical development nuclei. Thus, a light transmitting conductive film such as a light transmitting electromagnetic wave shielding film or an optically transparent conductive film is formed on the photosensitive material. This mode also falls within the category of the unified monochromic development type. Although the development process causes deposition on the physical development nuclei and thus achieves a high activity, the developed silver is in the form of spheres having a small surface area.

In the embodiment (3), silver halide grains are dissolved and diffused and then deposited on the physical development nuclei. Thus, a light transmitting conductive film such as a light transmitting electromagnetic wave shielding film or an optically transparent conductive film is formed on the image-receiving sheet. This mode falls within the category of the separate type, i.e., the image-receiving sheet is peeled off from the photosensitive material before using.

In each of these modes, selection may be made of the negative development or the reversal development (in the diffusion transfer system, negative development can be conducted by using an auto-positive photosensitive material as the photosensitive material).

The terms "chemical development", "heat development", "dissolution physical development" and "diffusion transfer development" as used herein have the meanings commonly employed in the art. These terms are illustrated in photochemical texts generally employed, for example, Shashin Kagaku, Shinichi Kikuchi (Kyoritsu Shuppan, 1955) and The Theory of Photographic Processes, 4th ed., ed. by C.E.K. Mees (Mcmillan, 1977). Although liquid processing is employed herein, the heat development system is also usable as the development system in other applications. Namely, use can be made of, for example, JP-A-2004-184693, JP-A-2004-334077, JP-A-2005-010752, Japanese Patent Application 2004-244080 and Japanese Patent Application 2004-085655.

### <Photosensitive material>

### [Support]

As the support of the photosensitive material to be used in the invention, use can be made of a plastic film, a plastic plate, a glass plate and so on.

As the material of the plastic film and plastic plate as described above, it is possible to use, for example, polyesters such as polyethylene terephthalate (PET) and polyethylene naphthalate; polyolefins such as polyethylene (PE), polypropylene (PP), polystyrene and EVA; vinyl-based resins such as polyvinyl chloride and polyvinylidene chloride; polyether ether ketone (PEEK), polysulfone (PSF), polyethersulfone (PES), polycarbonate (PC), polyamide, polyimide, acrylic resin, triacetyl cellulose (TAC) and so on.

In the present invention, it is preferable that the plastic film as described above is a polyethylene terephthalate film or a triacetyl cellulose (TAC) film from the viewpoints of transparency, heat resistance, easiness in handling and cost.

Since an electromagnetic wave shielding material for a display should be transparent, it is preferable that the support has a high transparency. In this case, the total visible light transmittance of the plastic film or the plastic plate is preferably from 70 to 100%, more preferably from 85 to 100% and particularly preferably from 90 to 100%. In the invention, it is also possible to use a plastic film or a plastic plate having been colored to such an extent as not to interfere the achievement of the objects of the invention.

The plastic film or plastic plate to be used in the invention may be either a single-layered one or a multilayered one comprising two or more layers combined together.

In the case of using a glass plate as the support in the invention, the kind of the glass is not particularly restricted. In the case of using as an electromagnetic wave shielding film for a display, it is preferable to use a hardened glass provided with a hardening layer on the surface. Compared with a non-hardened glass, a hardened glass can likely prevent breakage. A hardened glass obtained by the air-cooling method is still preferable from the viewpoint of safety, since it shatters into smaller pieces with non-sharp edges, if broken.

### [Protective layer]

The photosensitive material to be used herein may have a protective layer formed on the emulsion layer as will be described hereinafter. The term "protective layer" as used herein means a layer which is made of a binder such as gelatin or a high molecular polymer and formed on the photosensitive emulsion layer so as to exert effects of preventing scuff marks and improving mechanical properties. Taking the plating process into consideration, it is preferable not to form the protective layer or minimize the thickness thereof, if formed. The thickness of the protective layer is preferably 0.2 µm or less. The protective layer may be formed by any publicly known coating method without restriction.

### [Emulsion layer]

It is preferable that the photosensitive material to be used in the production method of the invention has an emulsion layer (a silver salt-containing layer), which contains a silver salt as a photosensor, on the support. The emulsion layer in the invention may optionally contain a dye, a binder, a solvent and so on, in addition to the silver salt.

### <Dye>

The photosensitive material may contain a dye at least in the emulsion layer. The dye is added to the emulsion layer for various purposes, i.e., as a filter dye, for preventing irradiation, or the like. As the dye, a solid dispersion dye may be contained. Examples of the dye preferably usable in the invention include the dyes represented by the general formulae (FA), (FA1), (FA2) and (FA3) as reported by JP-A-9-179243. More specifically speaking, compounds F1 to F34 cited in this patent document are preferred. Further, use may be preferably made of dyes (II-2) to (II-24) reported by JP-A-7-152112, dyes (III-5) to (III-18) reported by JP-A-7-152112, dyes (IV-2) to (IV-7) reported by JP-A-7-152112 and so on.

As other examples of the dye usable in the invention, there can be enumerated solid dyes in the form of fine grains that are to be leached in the course of the development or fixation such as cyanine dyes, pyrylium dyes and aminium dyes reported by JP-A-3-138640. Examples of a dye not bleached in processing include a cyanine dye having carboxyl group reported by JP-A-9-96891, an acid group-free cyanine dye reported by JP-A-8-245902, a lake type cyanine dye reported by JP-A-8-333519, a cyanine dye reported by JP-A-1-255536, a hollow porous type cyanine dye reported by JP-A-3-136038, a pyrylium dye reported by JP-A-62-299959, a polymer type cyanine dye reported by JP-A-7-253639, a fine grain dispersion of an oxonol dye reported by JP-A-2-282244, light-scattering grains reported by JP-A-63-131135, a Yb3+ compound reported by JP-A-9-5913, an ITO powder reported by JP-A-7-113072 and so on. Also, use can be made of dyes represented by the general formulae (F1) and (F2) reported by JP-A-9-179243, more specifically speaking, compounds F35 to F112 cited in this patent document.

The dyes as described above include water-soluble dyes. Examples of these water-soluble dyes include a oxonol dye, a benzylidene dye, a melocyanine dye, a cyanine dye and an azo dye. Among all, a oxonol dye, a hemioxonol dye and a benzylidene dye are particularly useful in the invention. Specific examples of the water-soluble dyes usable in the invention include those reported by British Patent 584,609, ibid. 1,177,429, JP-A-48-85130, JP-A-49-99620, JP-A-49-114420, JP-A-52-20822, JP-A-59-154439, JP-A-59-208548, US Patent 2,274,782, ibid. 2,533,472, ibid. 2, 956,879, ibid. 3,148,187, ibid. 3,177,078, ibid. 3,247,127, ibid. 3,540,887, ibid. 3, 575,704, ibid. 3,653,905 and ibid. 3,718,427.

The content of the dye in the emulsion layer preferably ranges from 0.01 to 10% by mass, more preferably from 0.1 to 5% by mass from the viewpoints of the effect of preventing irradiation and lowering in sensitivity due to an increase in the content thereof.

### <Silver salt>

As the silver salt to be used in the invention, there can be enumerated inorganic silver salts such as a silver halide. It is preferable in the invention to use a silver halide which has excellent characteristics as a photosensor.

Next, the silver halide preferably usable in the invention will be described.

It is preferable in the invention to use a silver halide so as to make it serving as a photosensor. Thus, techniques concerning a silver halide that have been employed in silver halide photofilms, photographic papers, plate-making films, emulsion masks for photomasking, etc. are also usable in the invention.

The halogen element to be contained in the silver halide as described above may be any one of chlorine, bromine, iodine and fluorine. Also, use may be made of a combination of these elements. For example, it is preferable to use a silver halide comprising, as the main component, AgCl, AgBr or AgI. It is also preferable to use a mixture of silver chloride and silver bromide, a mixture of silver iodide, silver chloride and silver bromide or a mixture of silver iodide and silver bromide. It is more preferable to use a mixture of silver chloride and silver bromide, silver bromide, a mixture of silver iodide, silver chloride and silver bromide or a mixture of silver iodide and silver bromide. It is most preferable to use a mixture of silver chloride and silver bromide or a mixture of silver iodide, silver chloride and silver bromide containing 50% by mol or more of silver chloride.

The expression "a silver halide containing AgBr (silver bromide) as the main component" as used herein means a silver halide in which the molar ratio of bromide ion in the silver halide composition amounts to 50% or more. The silver halide grains containing AgBr as the main component may contain bromide ion and chloride ion in addition to the bromide ion.

The silver halide is in the form of solid grains. Considering the image qualities in the patterned metal silver layer that is formed after the exposure and the development, it is preferable that the average grain size expressed in sphere-corresponding diameter is from 0.1 to 1000 nm (1 µm), more preferably from 0.1 to 100 nm and more preferably from 1 to 50 nm.

The term "sphere-corresponding diameter" of silver halide grains means the diameter of a spherical grain having the same volume.

The silver halide grains are not particularly restricted in shape. Namely, they may be in various shapes such as sphere, cube, plates (hexagonal plate, triangular plate, square plate, etc.), octagon, 14-hedron and so on. Cube or 14-hedron is preferable.

A silver halide grain may be composed of the interior and the surface area as a homogeneous phase. Alternatively, it may have a local layer having a different halogen composition either as the interior or the surface.

The silver halide emulsion to be used as a coating solution for emulsion layer in the invention can be prepared by using a method reported by, for example, G. Glafkides, Chimie et Physique Photographique (Paul Montel, 1997), G.F. Dufin, Photographic Emulsion Chemistry (The Forcal Press, 1966), V.L. Zelikman et al., Making and Coating Photographic Emulsion (The Forcal Press, 1964), etc.

As a method of preparing the silver halide emulsion as described above, either an acidic method or a neutral method may be used. As a method of reacting a soluble silver salt with a soluble halogen salt, use may be made of either a one-side mixing method, a simultaneous mixing method or a combination thereof.

To form silver grains, it is also possible to employ the method of forming the grains in the presence of excessive silver ion (i.e., the so-called reverse mixing method). As one of the simultaneous mixing methods, moreover, it is possible to employ the method wherein pAg is maintained at a constant level in the liquid phase for forming the silver halide, i.e., the so-called controlled double-jet method.

It is also preferable to from grains by using a so-called silver halide solvent such as ammonia, thioether or tetra-substituted thiourea. In these methods, it is particularly preferable to use a tetra-substituted thiourea compound as reported by JP-A-53-82408 and JP-A-55-77737. Preferable examples of the tetra-substituted thiourea compound include tetramethyl thioure and 1,3-dimethyl-2-imidazolinethione. Although the amount of the silver halide solvent to be added varies depending on the desired grain size and halogen composition, it preferably ranges from 10⁻⁵ to 10⁻² mol per mol of the silver halide.

By using the controlled double-jet method or the method of forming grains by using a silver halide solvent as described above, a silver halide emulsion having a regular crystal form and a narrow grain size distribution can be easily obtained. Therefore, these methods are preferably usable in the invention.

To uniformize the grain size, it is preferable to allow the quick growth of silver within a range not exceeding the critical saturation by using the method of varying the speed of adding silver nitride or an alkali halide depending on the grain growth speed as reported by British Patent 1,535,016, JP-B-48-36890 and JP-B-52-16354, or the method of varying the concentration of an aqueous solution as reported by British Patent 4,242,445 and JP-A-55-158124. The silver halide emulsion to be used in forming the emulsion layer in the invention is preferably a monodisperse emulsion preferably having a coefficient of variation represented by {(standard deviation of grain size)/(average grain size)}×100 of 20% or less, more preferably 15% or less and most preferably 10% or less.

The silver halide emulsion to be used in the invention may be a mixture of a plurality of silver halide emulsions having different grain sizes.

The silver halide emulsion to be used in the invention may contain a metal belonging to the VIII or VIIB group. To achieve a high contrast and a low fog, it is particularly preferable to contain a rhodium compound, an iridium compound, a ruthenium compound, an iron compound, an osmium compound, etc. These compounds may have various ligands. Examples of the ligands include a cyanide ion, a halogen ion, a thiocyanate ion, a nitrosyl ion, these pseudohalogens and ammonia as well as organic molecules such as amines (methylamine, ethylenediamine, etc.), heterocyclic compounds (imidazole, thiazole, 5-methyl thiazole, mercaptoimidazole, etc.), urea and thiourea.

To elevate the sensitivity, it is advantageous to use a dope of a metal hexacyanide complex dope such as K₄[Fe(CN)₆], K₄[Ru(CN)₆] or K₃[Cr(CN)₆].

As the rhodium compound as described above, use can be made in the invention a water-soluble rhodium compound. Examples of the water-soluble rhodium compound include a rhodium (III) halide, a hexachlororhodium (III) complex salt, a pentachloro acorhodium complex salt, a tetrachloro diagnorhodium complex salt, a hexabromorhodium (III) complex salt, a hexamine rhodium (III) complex salt, a trioxalatorhodium (III) complex salt, and K₃Rh₂Br₉.

Such rhodium compound is employed by dissolving in water or a suitable solvent. It is also possible to employ a common method for stabilizing the solution of the rhodium compound, namely a method of adding an aqueous solution of a hydrogen halide (such as hydrochloric acid, hydrobromic acid or hydrofluoric acid) or an alkali halide (such as KCl, NaCl, KBr or NaBr). It is also possible, instead of employing a water-soluble rhodium compound, to add and dissolve, at the preparation of silver halide, other silver halide grains having been doped with rhodium.

Examples of the above-described iridium compound include a hexachloroiridium complex salt such as K₂IrCl₆ or K₃IrCl₆, a hexabromoiridium complex salt, a hexaammineiridium complex salt and a pentachloronitrisil iridium complex salt.

Examples of the ruthenium compound as described above include hexachlororuthenium, pentachloro nitrosyl ruthenium, and K₄[Ru(CN)₆].

Examples of the iron compound as described above include potassium hexacyanoferrate (II) and ferrous thiocyanate.

Ruthenium or osmium is added in the form of a water-soluble complex salt as described in JP-A-63-2042, JP-A-1-285941, JP-A-2-20852 and JP-A-2-20855. As particularly preferable example, a 6-coordination complex represented by a following formula can be cited:

[ML₆]⁻ⁿ

wherein M represents Ru or Os; and n represents 0, 1, 2, 3 or 4.

In this case, a counter ion is not important and can for example be ammonium of an alkali metal ion. Also a preferable examples of the ligand include a halide ligand, a cyanide ligand, an oxycyanide ligand, a nitrosyl ligand and a thionitrosyl ligand. Next, specific examples of the complex usable in the invention will be shown, but the invention is not limited to such examples.

[RuCl₆]⁻³, [RuCl₄(H₂O)₂]⁻¹_{,} [RuCl₅(NO)]⁻², [RuBr₅(NS)]⁻², [Ru(CO)₃Cl₃]⁻², [Ru(CO)Cl₅]⁻², [Ru(CO)Br₅]⁻², [OsCl₆]⁻³, [OsCl₅(NO)]⁻², [Os(NO)(CN)₅]⁻², [Os(NS)Br₅]⁻², [Os(CN₆)]⁻⁴ and [Os(O)₂(CN)₅]⁻⁴.

Such a compound is preferably added in an amount of 10⁻¹⁰ to 10⁻² mol/mol.Ag per mol of silver halide, more preferably 10⁻⁹ to 10⁻³ mol/mol.Ag.

It is also preferable in the invention to use a silver halide containing a Pd (II) ion and/or a Pd metal. Pd may be uniformly distributed within a silver halide grain, but is preferably contained in the vicinity of a surface layer of the silver halide grain. The expression that Pd is "contained in the vicinity of a surface layer of the silver halide grain" means that the silver halide grain has a layer with a higher palladium content than in other layers, within a depth of 50 nm from the surface of the silver halide grain.

Such a silver halide grain can be prepared by adding Pd in the course of forming the silver halide grain, and it is preferable to add Pd after silver ions and halogen ions are added by more than 50% of the total addition amounts. It is also preferable that Pd (II) ions are made present in the surface layer of silver halide by adding Pd (II) ions in a post-ripening stage.

Such Pd-containing silver halide grains increase a speed of a physical development or an electroless plating to thereby improve the production efficiency of the desired electromagnetic wave shielding material. As a result, they contribute to a reduction of the production cost. Pd has been well known and employed as a catalyst for electroless plating, and, in the present invention, it is possible to localize Pd in the surface layer of the silver halide grains, thereby saving extremely expensive Pd.

In the invention, Pd ions and/or Pd metal preferably has a content, in the silver halide, of 10⁻⁴ to 0.5 mole/mol.Ag with respect to a number of moles of silver in silver halide, more preferably 0.01 to 0.3 mole/mol.Ag.

Examples of the Pd compound to be employed include PdCl₄ and Na₂PdCl₄.

In the invention, a chemical sensitization practiced in photographic emulsion can be conducted so as to further improve the sensitivity as the photosensor. As the chemical sensitization, use can be made of a chalcogen sensitization such as sulfur sensitization, selenium sensitization or tellurium sensitization, a precious metal sensitization such as gold sensitization, or a reduction sensitization. Such sensitization may be employed either singly or in combination. In case of employing a combination of chemical sensitizations as cited above, for example a combination of sulfur sensitization and gold sensitization, a combination of sulfur sensitization, selenium sensitization and gold sensitization, or a combination of sulfur sensitization, tellurium sensitization and gold sensitization is preferable.

The sulfur sensitization is normally conducted by adding a sulfur sensitizer and agitating the emulsion for a definite period of time at a high temperature of 40° C or above. As the sulfur sensitizer, use can be made of a known sulfur compound, for example, a sulfur compound contained in gelatin or various sulfur compounds such as a thiosulfate salt, a thiourea, a thiazole or a rhodanine. A preferred sulfur compound is a thiosulfate salt or a thiourea compound. The amount of the sulfur sensitizer to be added is variable depending on various conditions such as a pH and a temperature at the chemical ripening, and a grain size of the silver halide, and is preferably 10⁻⁷ to 10⁻² mol per mol of silver halide, more preferably 10⁻⁵ to 10⁻³ mol.

As the selenium sensitizer to be employed in the selenium sensitization, use can be made of a known selenium compound. The selenium sensitization is normally conducted by adding an unstable and/or non-unstable selenium compound and agitating the emulsion for a definite period time at a high temperature of 40° C or above. As the unstable selenium compound, use can be made of those described in JP-B-44-15748 JP-B-43-13489, JP-A-4-109240 and JP-A-4-324855. It is particularly preferable to use compounds represented by general formulas (VIII) and (IX) in JP-A-4-324855.

A tellurium sensitizer employed in the tellurium sensitization is a compound capable of generating silver telluride, which is assumed to constitute a sensitizing nucleus, on the surface or in the interior of silver halide grains. A silver telluride generating speed in the silver halide emulsion can be tested by a method described in JP-A-5-313284. Specific examples of the compound include those described in USP No. 1,623,499, ibid. No. 3,320,069, ibid. No. 3,772,031, British Patent No. 235,211, ibid. No. 1,121,496, ibid. No. 1,295,462, ibid. No. 1,396,696, Canadian Patent No. 800,958, JP-A-4-204640, JP-A-4-271341, JP-A-4-333043, JP-A-5-303157, J. Chem. Soc. Chem. Commun., 635 (1980), ibid., 1102(1979), ibid., 645(1979), J. Chem Soc. Perkin. Trans., 1, 2191(1980), S. Patai, The Chemistry of Organic Selenium and Tellurium Compounds, Vol. 1 (1986), and ibid., Vol. 2 (1987). Among all, compounds represented by the general formulas (II), (III) and (IV) in JP-A-5-313284 are preferred.

The amount of the selenium sensitizer or the tellurium sensitizer employable in the invention varies depending on the silver halide grains to be used and the condition of chemical ripening. In general, it ranges from 10⁻⁸ to 10⁻² mol per mol of the silver halide, preferably from 10⁻⁷ to 10⁻³ mol. The chemical sensitization in the invention is not particularly restricted in the conditions, but is usually conducted at a pH of 5 to 8, a pAg of 6 to 11, preferably 7 to 10 and a temperature of 40 to 95°C, preferably 45 to 85°C.

As the precious metal sensitizer, there can be employed gold, platinum, palladium or iridium, among which gold sensitization is particularly preferable. Examples of a gold sensitizer to be employed in the gold sensitization include chloroautic acid, potassium chloroaurate, potassium aurithiocyanate, gold sulfide, thioglucose gold (I) and thiomannose gold (I). Such a gold sensitizer can be employed in an amount of about 10⁻⁷ to about 10⁻² mol per mol of the silver halide. In the silver halide emulsion to be employed in the invention, a cadmium salt, a sulfite salt, a lead salt or a thallium salt may be included at the process of the formation of silver halide grains or of the physical ripening.

In the present invention, use can be also made of a reduction sensitization. As a reduction sensitizer, it is possible to employ a stannous salt, an amine, formamidinesulfinic acid or a silane compound. In the silver halide emulsion, a thiosulfonic acid compound. The silver halide emulsion may contain a thiosulfonic acid compound by a method described in European Patent (EP) No.293917. The silver halide emulsion to be employed in the preparation of the photosensitive material of the invention may be a single emulsion or a combination of two or more emulsions (for example, those differing in an average grain size, a halogen composition, a crystalline state, a condition of chemical sensitization or a sensitivity). In order to achieve a high contrast, it is preferable, as described in JP-A-6-324426, to coat an emulsion of a higher sensitivity in a position closer to the substrate.

### <Binder>

In the emulsion layer, use can be made of a binder for the purposes of uniformly dispersing the silver salt grains and assisting an adhesion between the emulsion layer and the substrate. As the binder in the invention, either a water-insoluble polymer or a water-soluble polymer is usable, though a water-soluble polymer is preferred.

Examples of the binder include gelatin, polyvinyl alcohol (PVA), polyvinylpyrrolidone (PVP), a polysaccharide such as starch, cellulose and a derivative thereof, polyethylene oxide, a polysaccharide, a polyvinylamine, chitosan, polylysine, polyacrylic acid, polyalginic acid, polyhyaluronic acid, carboxycellulose and so on. These materials have a neutral, anionic or cationic property depending on the ionic property of the functional group.

The amount of the binder contained in the emulsion layer is not particularly restricted, and can be suitably selected within a range of exerting the dispersibility and the adhesion.

### <Solvent>

A solvent to be employed in forming the above-described emulsion layer is not particularly restricted. For example, use can be made of water, an organic solvent (for example an alcohol such as methanol, a ketone such as acetone, an amide such as formamide, a sulfoxide such as dimethyl sulfoxide, an ester such as ethyl acetate, or an ether), an ionic liquid or a mixture thereof.

In the emulsion layer of the invention, the solvent is employed in an amount within a range of 30 to 90% by mass with respect to the total mass of the silver salt, the binder and the like contained in the emulsion layer, preferably within a range of 50 to 80% by mass.

### <Individual steps>

### [Exposure]

In the invention, an exposure is conducted to the silver salt-containing layer or a photosensitive layer coated with a photolithographic photopolymer provided on the support. The exposure can be conducted with an electromagnetic radiation. The electromagnetic radiation can be, for example, a visible light, a light such as ultraviolet light, or a radiation such as X-ray. Also the exposure can be conducted with a light source having a wavelength distribution, or a light source of a specified wavelength.

As the light source, use can be made of various light emitting substances showing a light emission in a visible spectral region, if necessary. For example a red light emitting substance, a green light emitting substance or a blue light emitting substance is employed either singly or in a mixture of two or more kinds. The spectral region is not limited to the aforementioned red, green and blue regions, and a light emitting substance, emitting light in a yellow, orange, purple or infrared region, can also be employed. In particular, use is frequently made of a cathode ray tube emitting a white light by mixing these light emitting substances. A ultraviolet lamp is also preferred, and g-line or i-line of a mercury lamp is also usable.

In the invention, it is preferable to conduct the exposure by using various laser beams. For example, the exposure in the invention can be preferably conducted by a scanning exposure method utilizing monochromatic high-density light of a gas laser, a light-emitting diode, a semiconductor laser, of a second harmonic generator (SHG) consisting of a combination of a semiconductor laser or a solid-state laser employing a semiconductor laser as an exciting light source and a non-linear optical crystal. Further, use can be also made a KrF excimer laser, an ArF excimer laser or an F2 laser therefor. For obtaining a compact and inexpensive system, it is preferable to conduct the exposure with the use of a semiconductor laser or a second harmonic generator (SHG) consisting of a combination of a semiconductor laser or a solid-state laser and a non-linear optical crystal. In order to design a particularly compact, inexpensive, long-life and highly stable apparatus, it is most desirable to conduct the exposure with the use of a semiconductor laser.

In the case of using a silver halide, the exposure energy is preferably 1 mJ/cm² or less, more preferably 100 µJ/cm² or less and more preferably 50 µJ/cm² or less.

Specific examples of the laser light source include a blue semiconductor laser of a wavelength of 430 to 460 nm (published by Nichia Chemical Co. at 48th United Meeting of Applied Physics (March, 2001); a green light laser of about 530 nm which is obtained by a wavelength conversion of a light of a semiconductor laser (oscillation wavelength of about 1060 nm) by a LiNbO₃ SHG crystal having a waveguide-type inverted domain structure; a red semiconductor laser of a wavelength of about 685 nm (Hitachi type: HL6738MG); and a red semiconductor laser of a wavelength of about 650 nm (Hitachi type: HL6501MG). As a ultraviolet to blue laser, it is preferable to use a laser having a wavelength of 300 nm or longer but not longer than 420 nm, more specifically a laser having a wavelength of about 365 nm or about 405 nm.

A pattern exposure of the silver salt-containing layer can be conducted by a scanning exposure with a laser beam. In particular, it is preferable to use a capstan laser scanning exposure device reported by JP-A-2000-39677. It is also preferred to employ a DMA in a light beam scanning system reported by JP-A-2000-1244 as a substitute for the beam-scanning under polygon mirror rotation in this capstan system.

### [Developing Process]

In the invention, a development process is conducted after the exposure of the emulsion layer. The development process can be conducted with the use of an ordinary technique employed in developing a silver halide photographic film or paper, a lithographic film, an emulsion mask for photomask or the like. A developing solution is not particularly restricted, and use can be made of a PQ developer, an MQ developer or an MAA developer. It is also possible to employ a commercially available product, for example, a developing solution or a developing solution in a kit, such as CN-16, CR-56, CP45X, FD-3, or Papitol manufactured by Fuji Film Co., or C-41, E-6, RA-4, D-19 or D-72 manufactured by Eastman Kodak Co. Also a lithographic developer can be employed.

As the lithographic developing solution, use can be made of, for example, D85 manufactured by Eastman Kodak Co. In the invention, a metallic silver part, preferably a patterned metallic silver part is formed in an exposed area, while a light transmitting part, which will explained hereinafter, is formed in an unexposed area by the exposure and the developing process as described above.

As the developing solution in the production method of the invention, use can be made of a developing agent of dihydroxybenzene type. Examples of the dihydroxybenzene developing agent include hydroquinone, chlorohydroquinone, isopropylhydroquinone, methylhydroquinone and hydroquinonemonosulfonate salt, among which hydroquinone is particularly preferable. As an auxiliary developing agent showing a super additivity with the above-described dihydroxybenzene developing agent, use can be made of a 1-phenyl-3-pyrrazolidone and a p-aminophenol. As the developing solution employed in the production method of the invention, use can be preferably made of a combination of a dihydroxybenzene developing agent with a 1-phenyl-3-pyrrazolidone or a combination of a dihydroxybenzene developing agent with a p-aminophenol.

Examples of a developing agent that can be combined with 1-phenyl-3-pyrrazolidone or a derivative thereof include 1-phenyl-3-pyrrazolidone, 1-phenyl-4,4-dimethyl-3-pyrrazolidone, 1-phenyl-4-methyl-4-hydroxymethyl-3-pyrrazolidone and so on.

Examples of the auxiliary developing agent of p-aminophenol type include N-methyl-p-aminophenol, p-aminophenol, N-(β-hydroxyethyl)-p-aminophenol, N-(4-hydroxyphenyl)glycine and so on, among which N-methyl-p-aminophenol is preferred. The dihydroxybenzene developing agent is usually employed in an amount of 0.05 to 0.8 mol/liter, but is preferably employed, in the invention, in an amount of 0.23 mol/liter or higher, more preferably in an amount within a range of 0.23 to 0.6 mol/liter. In the case of employing a combination of a dihydroxybenzene with a 1-phenyl-3-pyrrazolidone or a p-aminophenol, it is preferable to employ the former in an amount of 0.23 to 0.6 mol/liter, more preferably 0.23 to 0.5 mol/liter, and the latter in an amount of 0.06 mol/liter or less, more preferably 0.03 to 0.003 mol/liter.

In the invention, it is preferable that each of a development starter solution and a developer replenisher solution has a property of "showing a pH increase of 0.5 or less in the case of adding 0.1 mol of sodium hydroxide to 1 liter of the solution". This property of the development starter solution or the developer replenisher solution to be used can be confirmed by regulating the development starter solution or the developer replenisher solution to be tested at a pH value of 10.5, then adding 0.1 mol of sodium hydroxide to 1 liter of such solution and measuring the pH value of the solution. When the increase in the pH is 0.5 or less, the solution is evaluated as having the property as defined above. In the production method of the invention, it is preferable to use a development starter solution and a developer replenisher solution showing a pH increase of 0.4 or less in the above-described test.

To impart the above property to the development starter solution or the developer replenisher, a method utilizing a buffer is preferably utilized. As the buffer, use can be made of a carbonate salt, boric acid described in JP-A-62-186259, a sugar (such as saccharose) described in JP-A-60-93433, an oxime (such as acetoxime), a phenol (such as 5-sulfosalicylic acid), or a tertiary phosphate salt (such as a sodium salt or a potassium salt), preferably a carbonate salt or boric acid. It is preferable to use the buffer (particularly carbonate salt) in an amount of 0.25 mol/liter or higher, particularly preferably 0.25 to 1.5 mol/liter.

In the invention, the development starter solution preferably has a pH value of 9.0 to 11.0, particularly preferably 9.5 to 10.7. Also the pH values of the developer replenisher solution and the developing solution in a developing tank in a continuous processing fall within this range. To adjust pH, it is possible to use an alkali which is an ordinary water-soluble inorganic alkali metal salt (such as sodium hydroxide, potassium hydroxide, sodium carbonate or potassium carbonate).

In processing a photosensitive material of 1 m² in accordance with the production method of the invention, the content of the developer replenisher solution in the developing solution is 323 ml or less, preferably 323 to 30 ml and particularly preferably 225 to 50 ml. The developer replenisher solution may have the same composition as that of the development starter solution. Alternatively, it may have a higher concentration than that of the development starter solution concerning a component to be consumed in the development.

The developing solution for a developing process of the photosensitive material of the invention (hereinafter "development starter solution" and "developer replenisher solution" will be sometimes collectively referred to as "developing solution") may contain an ordinary additive (such as a stabilizer or a chelating agent). Examples of the stabilizer include a sulfite salt such as sodium sulfite, potassium sulfite, lithium sulfite, ammonium sulfite, sodium bisulfite, potassium metabisulfite, sodium formaldehyde bisulfite and so on. It is preferable to use the sulfite salt d in an amount of 0.20 mol/liter or higher, more preferably 0.3 mol/liter or higher. However, it is preferable that the upper limit thereof is 1.2 mol/liter, since excessive addition thereof causes a silver stain in the developing solution. A particularly preferred range is 0.35 to 0.7 mol/liter. It is also possible to use, as a stabilizer for a dihydroxybenzene developing agent, a small amount of an ascorbic acid derivative in combination with the sulfite salt. Examples of the ascorbic acid derivative include ascorbic acid, erysorbic acid which is a steric isomer thereof and an alkali metal salt thereof (such as sodium salt or potassium salt). As the ascorbic acid derivative, sodium erysorbate is preferably employed from the viewpoint of the material cost. It is preferable to use the ascorbic acid derivative in an amount within a range of 0.03 to 0.12 in a molar ratio to the dihydroxybenzene developing agent, particularly preferably within a range of 0.05 to 0.10. In the case of employing an ascorbic acid derivative as the stabilizer, it is preferable that the developing solution preferably contains no boron compound.

Other additives usable in the developing solution include a development inhibitor such as sodium bromide or potassium bromide; an organic solvent such as ethylene glycol, diethylene glycol, triethylene glycol or dimethylformamide; a development promoter, for example, an alkanolamine such as diethanolamine or triethanolamine, imidazole or a derivative thereof; and a mercapto compound, an indazole compound, a benzotriazole compound or a benzoimidazole compound as an antifoggant or a black pepper spot preventing agent. Specific examples of the benzoimidazole compound as described above include 5-nitroindazole, 5-p-nitrobenzoylaminoindazole, 1-methyl-5-nitroindazole, 6-nitroindazole, 3-methyl-5-nitroindazole, 5-nitrobenzimidazole, 2-isopropyl-5-nitrobenzimidazole, 5-nitrobenzotriazole, sodium 4-[(2-mercapto-1,3,4-thiadiazol-2-yl)thio]butanesulfonate, 5-amino-1,3,4-thiadiazole-2-thiol, methylbenzotriazole, 5-methylbenzotriazole, 2-mercaptobenzotriazole and so on. The benzoimidazole compound is employed usually in a content of 0.01 to 10 mmol per liter of the developing solution, more preferably 0.1 to 2 mmol.

The developing solution may further contain an organic or inorganic chelating agent. Examples of the inorganic chelating agent include sodium tetrapolyphosphate, sodium hexametaphosphate and so on. As the organic chelating agent, use can be principally made of an organic carboxylic acid, an aminopolycarboxylic acid, an organic phosphonic acid, an aminophosphonic acid or an organic phopohonocarboxylic acid.

Examples of the organic carboxylic acid as described above include acrylic acid, oxalic acid, malonic acid, succinic acid, glutaric acid, adipic acid, pimelic acid, succinic acid, azelaic acid, sebacic acid, nonanedicarboxylic acid, decanedicarboxylic acid, undecanedicarboxylic acid, maleic acid, itaconic acid, malic acid, citric acid, tartaric acid and so on, though the invention is not restricted thereto.

Examples of the aminopolycarboxylic acid as described above include iminodiacetic acid, nitrilotriacetic acid, nitrilotripropionic acid, ethylenediamine monohydroxyethyltriacetic acid, ethylenediamine tetraacetic acid, glycol ether tetraacetic acid, 1,2-diaminopropane tetraacetic acid, diethylenetriamine pentaacetic acid, triethylenetetramine hexaacetic acid, 1,3-diamino-2-propanol tetraacetic acid, glycol ether diamine tetraacetic acid, and compounds described in JP-A-52-25632, JP-A-55-67747, JP-A-57-102624 and JP-B No. 53-40900.

Examples of the organic phosphonic acid include a hydroxyalkylidene diphosphonic acid described in USP No. 3,214,454, USP No. 3,794,591 and GP-A No. 2227639, or a compound described in Research Disclosure, vol. 181, Item 18170 (May 1979).

Examples of the aminophosphonic acid as described above include aminotris(methylenephosphonic acid), ethylenediamine tetramethylenephosphonic acid, aminotrimethylene phosphonic acid and so on. Also, use can be made of compounds described in Research Disclosure No. 18170, JP-A-57-208554, JP-A-54-61125, JP-A-55-29883 and JP-A-56-97347.

Examples of the phosphonocarboxylic acid include compounds described in JP-A-52-102726, JP-A-53-42730, JP-A-54-121127, JP-A-55-4024, JP-A-55-4025, JP-A-55-126241, JP-A-55-65955, JP-A-55-65956 and Research Disclosure No. 18170. The chelating agent may be employed in the form of an alkali metal salt or an ammonium salt.

The chelating agent is preferably added in an amount of 1 × 10⁻⁴ to 1×10⁻¹ mol, more preferably 1 × 10⁻³ to 1 × 10⁻² mol, per 1 liter of the developing solution.

The developing solution may further contain, as a silver stain preventing agent, a compound described in JP-A-56-24347 and JP-A- 56-46585, JP-B-62-2849 and JP-A-4-362942. As an auxiliary solvent, use can be also made of a compound described in JP-A-61-267759. The developing solution may further contain a color toning agent, a surfactant, a defoamer, a hardening agent and the like, if necessary. A developing temperature and a developing time are mutually related and are determined depending on a total process time. In general, however, the developing temperature is preferably about 20 to 50°C, more preferably 25 to 45°C. Also the developing time is preferably 5 seconds to 2 minutes, more preferably 7 to 90 seconds.

For the purposes of saving a transportation cost, a packing cost and a space of the developing solution, there is also preferred an embodiment of concentrating the developing solution and diluting it before using. To concentrate the developing solution, it is effective to employ potassium salts in the salts contained in the developing solution.

The development process in the invention can involve a fixing process conducting for the purpose of eliminating the silver salt in an unexposed area thereby achieving stabilization. The fixing process in the invention can be conducted by using a fixing technique commonly employed, for example, in a silver halide photographic film or paper, a lithographic film or an emulsion mask for photomask.

Preferable components of the fixing solution employed in the fixing step are as follows. Namely, it is preferable that the fixing solution contains sodium thiosulfate or ammonium thiosulfate, and, if necessary tartaric acid, citric acid, gluconic acid, boric acid, iminodiacetic acid, 5-sulfosalicylic acid, glucoheptanoic acid, tiron, ethylenediamine tetraacetic acid, diethylenetriamine pentaacetic acid, nitrotriacetic acid, a salt thereof or the like. From the standpoint of recent environmental consideration, it is favorable to contain no boric acid. Examples of the fixing agent in the fixing solution to be employed in the invention include sodium thiosulfate, ammonium thiosulfate and so on. From the viewpoint of the fixing speed, ammonium thiosulfate is preferred. From the standpoint of recent environmental consideration, however, sodium thiosulfate may also be employed. Although the amount of such a known fixing agent may be appropriately varied, it generally ranges from about 0.1 to about 2 mol/liter, preferably 0.2 to 1.5 mol/liter. The fixing solution may contain, if desired, a hardening agent (such as a water-soluble aluminum compound), a stabilizer (such as a sulfite salt, or a bisulfite salt), a pH buffer (such as acetic acid), a pH regulating agent (such as ammonia or sulfuric acid), a chelating agent, a surfactant, a humidifying agent, a fixing promoter and so on.

Examples of the surfactant as described above include an anionic surfactant such as a sulfate compound or a sulfonated compound, a polyethylene-based surfactant, or an amphoteric surfactant described in JP-A-57-6740. Also the fixing solution may contain a publicly known defoaming agent.

Examples of the humidifying agent as described above include an alkanolamine, an alkylene glycol and so on. As the fixing promoter, it is also possible to use a thiourea derivative described in JP-B-5-35754, JP-B-58-122535 and JP-B-58-122536; an alcohol having a triple bond in the molecule; a thioether compound described in USP No. 4,126,459; a mesoion compound described in JP-A-4-229860; or a compound described in JP-A-2-44355. Examples of the pH buffer as described above include an organic acid such as acetic acid, malic acid, succinic acid, tartaric acid, citric acid, oxalic acid, maleic acid, glycolic acid, or adipic acid; and an inorganic buffer such as boric acid, a phosphate salt or a sulfite salt. The pH buffer is preferably acetic acid, tartaric acid or a sulfite salt. The pH buffer is employed for the purpose of preventing a pH increase in the fixing solution by a carry-over of the developing solution, preferably in an amount of 0.01 to 1.0 mol/liter, more preferably 0.02 to 0.6 mol/liter. The fixing solution preferably has a pH value of 4.0 to 6.5, particularly preferably 4.5 to 6.0. As a dye dissolution promoter, it is also possible to use a compound described in JP-A-64-4739.

Examples of the hardening agent to be employed in the fixing solution of the invention include a water-soluble aluminum salt and a chromium salt. It is preferable that the hardening agent is a water-soluble aluminum salt, such as aluminum chloride, aluminum sulfate or potassium alum, and is preferably added in an mount of 0.01 to 0.2 mol/liter, more preferably 0.03 to 0.08 mol/liter.

In the fixing step as described above, a fixing temperature is preferably about 20°C to about 50°C, more preferably 25 to 45° C, while a fixing time is preferably 5 seconds to 1 minute, more preferably 7 to 50 seconds. A replenishing amount of the fixing solution is preferably 600 ml/m² or less to the processed amount of the photosensitive material, more preferably 500 ml/m² or less and particularly preferably 300 ml/m² or less.

The photosensitive material having been subjected to the developing and fixing processes is preferably subjected to a rinsing process or a stabilization process. In the rinsing process or the stabilization process, the rinsing is usually conducted with water in an amount of 20 liters or less per m² of the photosensitive material, with a replenishing amount of 3 liters or less (including 0, namely rinsing in a standing water bath). It is therefore possible not only to achieve a water saving but also to dispense with a piping in an automatic processor. For reducing the replenishing amount of rinsing water, there is already known a multi-step (2- or 3-step) countercurrent system. In the case of using such a multi-step countercurrent system in the production method of the invention, the photosensitive material after the fixing step is processed in succession in a proper direction, namely toward a processing solution less contaminated with the fixing solution, whereby a more efficient rinsing can be achieved. Also in the case of conducting the rinsing operation with a small amount of water, there is preferably provided a rinsing tank with a squeeze roller or a crossover roller as described in JP-A-63-18350 and JP-A-62-287252. Also in order to alleviate a pollution which may arise in the rinsing with a small amount of water, use may be made of a combination of an addition of various oxidants or a filtration with a filter. Also in such a method, an overflowing liquid from a rinsing bath or a stabilizing bath, resulting from a replenishment of the rinsing bath or the stabilizing bath with water including antimold means, or a part of such overflowing liquid may be utilized as a processing solution having a fixing ability in a preceding process step, as described in JP-A-60-235133. Also a water-soluble surfactant or a defoaming agent may be added in order to prevent a bubble pattern which tends to be generated in the rising with a small amount of water and/or a transfer of a processing component from the squeeze roller to the processed film.

Also in the rinsing process or the stabilization process, a dye adsorbent described in JP-A-63-163456 may be provided in the rinsing bath so as to prevent a stain by a dye dissolved from the photosensitive material. Also in the stabilizing process succeeding to the rinsing process, a bath containing a compound described in JP-A-2-201357, JP-A-2-132435, JP-A-1-102553 and JP-A-46-44446 may be employed as a final bath for the photosensitive material. In this case, it is possible to add, if necessary, an ammonium compound, a metal compound such as of Bi or Al, a fluorescent whitening agent, a chelating agent, a film pH regulating agent, a hardening agent, an antiseptic, an antimold agent, an alkanolamine or a surfactant. The water employed in the rinsing process or the stabilization process may be tap water, or preferably deionized water or water sterilized with a halogen, a ultraviolet sterilizing lamp or an oxidant (such as ozone, hydrogen peroxide or a perchlorate salt). It is also possible to employ rinsing water containing a compound described in JP-A-4-39652 and JP-A-5-241309. In the rinsing process or the stabilization process, it is preferable to employ a bath temperature of 0 to 50° C and a bathing time of 5 seconds to 2 minutes.

The processing solution such as the developing solution or the fixing solution to be employed in the invention is preferably stored in a packaging material of a low oxygen permeability, as described in JP-A-61-73147. To reduce the replenishing amount, it is also preferable that a contact area of the processing tank with the air is made smaller to avoid evaporation of the solution and atmospheric oxidation. An automatic processor of a roller conveying type is described, for example, in USP Nos. 3,025,779 and 3,545,971, and will be simply referred to as a roller conveying processor hereinafter. The roller conveying processor is preferably comprises four steps of development, fixing, rinsing and drying. Although these four steps are most preferably adopted in the present invention, another step (such as stopping step) will not be excluded. Also the four steps may employ a stabilizing step instead of the rinsing step.

In each of the above-described steps, components of the developing solution or the fixing solution may be supplied as a solid by eliminating water, and may be dissolved before using in a predetermined amount of water to form a developing solution or a fixing solution. The processing material of such a form is called a solid processing material. The solid processing material is utilized in the form of a powder, a tablet, granules, a block or a paste. A preferred form of the processing material is a form as described in JP-A-61-259921 or a tablet. Such a tablet can be produced by a commonly employed method described in, for example, JP-A-51-61837, JP-A-54-155038, JP-A-52-88025, and BP No.1,213,808. The solid processing material in the form of granules can be produced by a commonly employed method described in, for example, JP-A-2-109042, JP-A-2-109043, JP-A-3-39735 and JP-A-3-39739. The processing material in the form of a powder can be produced by a commonly employed method described in, for example, JP-A-54-133332, BP Nos. 725,892 and 729,862 and GP No. 3,733,861.

Taking the solubility into consideration, the solid processing material preferably has a bulk density of 0.5 to 6.0 g/cm³, more preferably 1.0 to 5.0 g/cm³.

To prepare the solid processing material, use can be made of a method which comprises providing reactive substances in such a layered manner that at least two mutually reactive granular substances, in the substances constituting the processing material, constitute layers separated by at least an intermediate separating layer of a substance inert to the reactive substances, then employing a bag capable of vacuum packing as a packaging material and evacuating and sealing the bag. The term "inert" as used herein means that the substances in mutual contact do not react in an ordinary state in the package nor cause a significant reaction. The inactive substance may be inert to the two mutually reactive substances or may be inert in the intended use of the two mutually reactive substances. Also the inert substance is a substance to be employed simultaneously with the two reactive substances. For example, in the developing solution, since hydroquinone and sodium hydroxide react in a direct contact, sodium sulfite or the like may be employed as a separating layer between hydroquinone and sodium hydroxide in the vacuum package, thereby enabling a prolonged storage. Also hydroquinone or the like may be formed in briquettes to reduce the contact area with sodium hydroxide, thereby improving storage properties and enabling use as a mixture. As a packaging material for such vacuum package, use can be made of a bag formed from an inert plastic film or a laminate of a plastic material and a metal foil.

A mass of metallic silver contained in an exposed area after the development process is preferably 50% by mass or more, based on the mass of silver contained in the exposed area prior to the exposure, more preferably 80% by mass or more. It is preferable that metallic silver contained in an exposed area in an amount of 50% by mass or more based on the mass of silver contained in such exposed area prior to the exposure, since a high electroconductivity can be obtained in this case.

Although the gradation to be conducted after the development process of the invention is not particularly restricted, it is preferably higher than 4.0. A gradation higher than 4.0 after the development process allows to increase the conductivity in the conductive metal part while maintaining a high transparency in the light transmitting part. A gradation higher than 4.0 can be obtained by, for example, doping with rhodium ions or iridium ions as described above.

### [Physical Development and Plating Process]

In order to impart an electroconductivity to a metallic silver part formed by the exposure and the development process, a physical development and/or a plating process are conducted in the invention so as to make the metallic silver part to carry conductive metal particles. In the invention, the conductive metal particles can be carried on the metallic silver part by either of the physical development and the plating process. Moreover, such carrying of the conductive metal particles on the metallic silver part may also be achieved by combining the physical development and the plating process. A metallic silver part, which has been subjected to the physical development and/or the plating process" is called a "conductive metal part".

The term "physical development" as used in the invention means to reduce a metal ion such as a silver ion with a reducing agent to deposit metal particles on a nucleus of a metal or a metal compound. This physical development has been employed in an instant monochromatic film, an instant slide film or a lithographic film, and these techniques can be utilized in the present invention.

The physical development may be conducted simultaneously with the development process after the exposure, or separately after the development process.

In the invention, a plating process may be an electroless plating (chemical reduction plating or substitution plating) and/or an electrolytic plating. The electroless plating in the invention can be conducted with the use of a known electroless plating technique, e.g., that has been utilized in, for example, a printing wiring board, and is preferably an electroless copper plating.

Examples of the chemical species contained in an electroless copper plating solution include copper sulfate or copper chloride, a reducing agent such as formalin or glyoxylic acid, a copper ligand such as EDTA or triethanolamine, and additives for bath stabilization and for improving smoothness of a plated film such as polyethylene glycol, a ferrocyanate salt or bipyridine.

An electrolytic copper plating bath may be a copper sulfate bath or a copper pyrophosphate bath.

The plating process in the invention can be conducted under mild plating speed conditions or at a high plating speed of 5 µm/hr or higher. In the plating process, use can be made of various additives such as a ligand such as EDTA so as to improve the stability of the plating solution,.

### [Oxidation process]

It is preferable in the invention that a metallic silver part after the development process and a conductive metal part formed by the physical development and/or the plating process are subjected to an oxidation process. By conducting the oxidation process, it is possible to eliminate a metal eventually slightly deposited in a light transmitting part, thereby obtaining a transparency of approximately 100% in the light transmitting part.

The oxidation process can be conducted by a known process utilizing various oxidants, such as process with Fe (III) ions. As described above, the oxidation process can be conducted after the exposure and the development process of the emulsion layer or after the physical development or the plating process, conducted after the development process and after the physical development or the plating process.

In the invention, it is furthermore possible to treat the metallic silver part after the exposure and the development process, with a Pd-containing solution. Pd may be a divalent palladium ion or metallic Pd. Owing to this treatment, it is possible to accelerate the electroless plating or the physical development.

### [Conductive Metal Part]

In the case of using as a light transmitting electromagnetic wave shielding material, the conductive metal part in the invention preferably has a geometrical shape formed by a combination of a triangular shape such as an equilateral triangle, an isosceles triangle, or a right-angled triangle, a quadrilateral such as a square, a rectangle, a rhombus, a parallelogram, or a trapezoid, a regular (n)-polygon such as a regular hexagon or a regular octagon, a circle, an oval or a star-shape, and more preferably a mesh constituted of such geometrical shapes. A triangular shape is most effective from the viewpoint of the EMI shielding property, but, in consideration of the visible light transmittance, a regular (n)-polygon with a larger number n is advantageous as it provides a larger aperture rate for a same line width thereby increasing the visible light transmittance. To minimize moire, it is also preferable to provide these geometrical shapes at random or non-periodically alter the line width.

In the case of using as a conductive wiring material, the conductive metal part is not particularly restricted in the shape, and can be selected in an arbitrary shape according to the purpose.

In the case where the thin lines in the conductive metal part comprising developed silver in the invention have a line width of 30 µm or more, there frequently arise band-shaped image irregularities in a combination with a PDP module. In the case where the line width is 1 µm or less, it is impossible to achieve such a high electroconductivity as shielding electromagnetic wave. Taking these factors into consideration, it is preferable that the thin lines in the conductive metal part comprising developed silver in the invention have a line width of from 1 to 30 µm, more preferably from 5 to 25 µm and most preferably from 10 to 20 µm.

In the case of using as a light transmitting electromagnetic wave shielding material, the thin lines in the conductive metal part should be regulated to 1 µm or more but not more than 40 µm, preferably 5 µm or more but not more than 30 µm and most preferably 10 µm or more but not more than 25 µm. The line intervals is preferably 50 µm or more but not more than 500 µm, more preferably 200 µm or more but not more than 400 µm and most preferably 250 µm or more but not more than 350 µm. For the purpose of grounding or the like, the conductive metal part may have a section having a line width exceeding 20 µm.

The conductive metal part in the invention preferably has an aperture rate of 85% or higher in consideration of the visible light transmittance, more preferably 90% or higher and most preferably 95% or higher. The term "aperture rate" as used herein means a ratio of a part outside the fine line constituting the mesh in the entire area, and, for example, a square lattice mesh of a line width of 15 µm and a pitch of 300 µm has an aperture rate of 90%.

### [Light Transmitting Part]

The term "light transmitting part" as used herein means a part having transparency, other than the conductive metal part in the light transmitting electromagnetic wave shielding film. As discussed above, "transmittance of the light transmitting part" means a part having a transmittance indicated by the minimum transmittance within a wavelength region of 380 to 780 nm, excluding contributions of an absorption and a reflection of the substrate, of 90% or higher, more preferably 95% or higher, further preferably 97% or higher, further more preferably 98% or higher and most preferably 99% or higher.

The mesh pattern in the invention should continue for 3 m or longer. A mode having a larger repetition number is preferred, since a loss in producing the optical filter material can be thus reduced. On the other hand, an increase in the repetition frequently causes such problems as the roll diameter being increased in winding into a roll, the roll becoming heavier, and the pressure at the roll center being elevated to cause troubles including adhesion and deformation. Thus, it is preferable that the length of the mesh pattern is not longer than 2000 m, preferably 100 m or longer but not longer than 1000 m, more preferably 200 m or longer but not longer than 800 m and most preferably 300 m or longer but not longer than 500 m.

For the same reasons, the thickness of the support is preferably 200 µm or less, more preferably 20 µm or more but not more than 180 µm and most preferably 50 µm or more but not more than 120 µm.

Another object of the present invention is to provide an electromagnetic wave shielding material by which the efficiency in the continuous production can be elevated. The term "continuous production" as used herein means the production of multiple optical filter sheets by using a single electromagnetic wave shielding material roll. There are seemingly various sizes of optical filters depending on the module sizes to be combined. In the invention, it is preferable that an optical filter has a width of 2 cm or more, more preferably from 50 cm to 150 cm so as to fit for PDP modules of 37 in. to 110 in. Although a longer electromagnetic wave shielding material roll is preferred from the viewpoint of the efficiency in the continuous production, the length of a single roll is preferably form 3 m to 2000 m, more preferably from 100 m to 1000 m by taking the restriction imposed by the roll weight, roll diameter and so on into consideration.

The expression "a pattern made up of straight thin lines, which are being arranged substantially in parallel, intersecting with each other" as used herein means a so-called lattice pattern wherein thin lines adjacent to each other, which constitute the lattice pattern, are in parallel or aligned at an angle within ±2° to being parallel.

Concerning the scanning method with the light beam, it is preferable to employ a method wherein the exposure is conducted by using linear light sources aligned substantially perpendicular to the transport direction or a rotational polygon mirror. In this case, the light intensity of the light beams should be modulated to have two or more values including the state of being substantially zero. A straight line is patterned as continuous dots. Because of being continuous dots, the thin line of a single dot has a stepwise edge. The thickness of the thin line corresponds to the width at the narrowest portion.

As another light scanning method, it is also preferable to scan light beams inclined to the transport direction fitting for the inclination of the lattice pattern. In this case, it is preferable to orthogonalize two scanning light beams so that the light intensity of the light beams on the exposure face becomes substantially 1.

It is preferable in the invention to incline the mesh pattern at an angle of 30° to 60° to the transport direction, more preferably 40° to 50° and most preferably 43° to 47°. This is because a mask having an inclination of the mesh pattern at about 45° to a frame can be hardly manufactured in general and is accompanied by some problems including occurrence of unevenness and an elevation in the cost. In the above-described method, on the other hand, unevenness is rather relieved at around 45° and, therefore, the advantages of the present invention become noticeable compared with photolithography of the mask aligner exposure system or patterning by screen printing.

### [Light transmitting electromagnetic wave shielding film]

In the light transmitting electromagnetic wave shielding film of the invention, the support preferably has a thickness of 5 to 200 µm, and more preferably 30 to 150 µm. So long as the thickness falls within the range of 5 to 200 µm, a desired transmittance for the visible light and easiness in handling can be established.

The metallic silver part, that has been formed on the support before the physical development and/or the plating process, has a thickness which can be suitably determined according to a coating thickness of a coating liquid for a silver salt-containing layer, to be coated on the support. The thickness of the metallic silver part is preferably 30 µm or less, more preferably 20 µm or less, further preferably 0.01 to 9 µm and most preferably 0.05 to 5 µm. The metallic silver part is preferably provided in a patterned shape. Also the metallic silver part may be constituted of a single layer or may have a multi-layered structure of two or more layers. In the case where the metallic silver part has a patterned shape and a multi-layered structure of two or more layers, it is possible to impart different photosensitivities to these layers so as to make them sensitive to different wavelengths. Thus, it becomes possible that exposures with different exposing wavelengths enable the formation of different patterns in such layers. The light transmitting electromagnetic wave shielding film including thus formed patterned metallic silver parts of a multi-layered structure is usable as a high-density printed circuit board.

In the case of using as an electromagnetic wave shielding material for a display, the conductive metal part preferably has an as small thickness as possible for increasing a viewing angle of the display. In the case of using as a conductive wiring material, a thinner film is required for achieving a higher density. From these points of view, the layer of the conductive metal carried on the conductive metal part preferably has a thickness less than 9 µm, more preferably 0.1 µm or more but less than 5 µm and further preferably 0.1 µm or more but less than 3 µm.

In the present invention, since it is possible to form a metallic silver part of a desired thickness by controlling the coating thickness of the emulsion layer and to arbitrarily control the layer of the conductive metal particles by the physical development and/or the plating plate, even a light transmitting electromagnetic wave shielding film of a thickness less than 5 µm, preferably less than 3 µm, can be easily formed.

In contrast to a known etching process in which a large part of the metal thin film has to be etched off and discarded, the present invention, being capable of forming a pattern containing a conductive metal of a necessary amount only on the support, can only utilize the metal of a necessary minimum amount, thereby attaining advantages of reductions in the production cost and in the amount of discarded metal.

### <Adhesive layer>

In the case of integrating into an optical filter, a liquid crystal display panel, a plasma display panel, another image display Glat panel, a image-picking semiconductor integrated circuit typified by a CCD, the electromagnetic wave shielding film according to the invention is bonded via an adhesive layer.

In the adhesive layer, it is preferable to employ an adhesive having a refractive index of from 1.40 to 1.70. This is because a lowering in the visible light transmittance can be prevented by minimizing the difference in refractive index between the adhesive and a transparent base such as a plastic film to be used in the invention. So long as the refractive index falls within the range of 1.40 to 1.70, the visible light transmittance is scarcely lowered and favorable results can be obtained.

It is preferable to use an adhesive that becomes flowable by heating or pressurizing. An adhesive showing flowability when heated to 200°C or lower or pressurizing at 1 kgf/cm² or more is particularly preferred. By using such an adhesive, it is possible to make the adhesive layer flowable to thereby bond the electromagnetic wave shielding film according to the invention, wherein a conductive layer is embedded in this adhesive layer, to an adherend such as a display or a plastic plate. Because of being flowable, the adhesive layer makes it possible to easily bond the electromagnetic wave shielding material to an adherend by laminating, pressure forming, in particular, pressure forming even to an adherend having a curved face or a complicated shape. For this purpose, it is preferable that the softening point of the adhesive is 200°C or lower. Since the electromagnetic wave shielding material is usually employed at a temperature lower than 80°C for the purposes of using, it is preferable that the softening point of the adhesive is 80°C or higher, most preferably from 80 to 120°C by taking the processability into consideration. The term "softening point" means a temperature at which the viscosity becomes 10¹² poise or lower. At such a temperature, a substance becomes flowable within about 1 to 10 seconds.

Typical examples of the adhesive which becomes flowable by heating or pressurizing as described above include thermoplastic resins as will be cited below. That is, use can be made therefor of natural rubber (refractive index n=1.52), polyisoprene (n=1.521), poly-1,2-butadiene (n=1.50), polyisobutene (n=1.505 to 1.51), polybutene (n=1.513), dienes such as poly-2-heptyl-1,3-butadiene (n=1.50), poly-2-t-butyl-1,3-butadiene (n=1.506) and poly-1,3-butadiene (n=1.515), polyoxyethylene (n=1.456), polyoxypropylene (n=1.450), polyethers such as polyvinyl ethyl ether (n=1.454), polyvinyl hexyl ether (n=1.459) and polyvinyl butyl ether (n=1.456), polyesters such as polyvinyl acetate (n=1.467) and polyvinyl propionate (n=1.467), polyurethane (n=1.5 to 1.6), ethyl cellulose (n=1.479), polyvinyl chloride (n=1.54 to 1.55), polyacrylonitrile (n=1.52), polymethacrylonitrile (n=1.52), polysulfone (n=1.633), polysulfide (n=1.6), a phenoxy resin (n=1.5 to 1.6), and poly(meth)acrylic esters such as polyethyl acrylate (n=1.469), polybutyl acrylate (n=1.466), poly-2-ethylhexyl acrylate (n=1.463), poly-t-butyl acrylate (n=1.464), poly-3-ethoxypropyl acrylate (n=1.465), polyoxycarbonyl tetramethylene (n=1.465), polymethyl acrylate (n=1.472 to 1.480), polyisopropyl methacrylate (n=1.473), polydodecyl methacrylate (n=1.474), polytetradecyl methacrylate (n=1.475), poly-n-propyl methacrylate (n=1.484), poly-3,3,5-trimethylcyclohexyl methacrylate (n=1.484), polyethyl methacrylate (n=1.485), poly-2-nitro-2-methylpropyl methacrylate (n=1.487), poly-1,1-diethylpropyl methacrylate (n=1.489) and polymethyl methacrylate (n=1.489). If necessary, two or more kinds of these acryl polymers may be copolymerized. It is also possible to use a blend of two or more kinds thereof.

As a resin obtained by copolymerizing an acrylic resin with a resin other than acrylic resins, use can be also made of an epoxy acrylate (n=1.48 to 1.60), a urethane acrylate (n=1.5 to 1.6), a polyether acrylate (n=1.48 to 1.49), a polyester acrylate (n=1.48 to 1.54) and so on. From the viewpoint of adhesiveness, a urethane acrylate, an epoxy acrylate and a polyether acrylate are excellent. Examples of the epoxy acrylate include (meth)acrylic acid adducts of 1,6-hexanediol diglycidyl ether, neopentyl glycol diglycidyl ether, allyl alcohol diglycidyl ether, resorcinol diglycidyl ether, diglycidyl adipate, diglycidyl phthalate, polyethylene glycol diglycidyl ether, trimethylolpropane triglycidyl ether, glycerol triglycidyl ether, pentaerythritol tetraglycidyl ether, sorbitol tetraglycidyl ether and so on. A polymer having a hydroxyl group in its molecule such as an epoxy acrylate is effective in improving adhesiveness. If necessary, two or more kinds of these copolymer resins may be used together. From the viewpoint of handling properties, the softening point of such a polymer to be used an adhesive is appropriately 200°C or lower and preferably 150°C or lower. Since the electromagnetic wave shielding material is usually employed at a temperature lower than 80°C for the purposes of using, it is preferable that the softening point of the adhesive is 80 to 120°C by taking the processability into consideration. On the other hand, it is preferable to use a polymer having a weight-average molecular weight (a value measured by using a calibration curve obtained by gel permeation chromatography using polystyrene as a standard; the same will apply hereinafter) of 500 or more. A polymer having a molecular weight is less than 500 can impart only an insufficient cohesive force to an adhesive composition, which results in a fear of lowering the adhesiveness to an adherend. The adhesive to be used in the invention may contain, if necessary, an additive such as a diluent, a plasticizer, an antioxidant, a filler, a coloring agent, a ultraviolet absorber or a tackifier. The thickness of the adhesive layer is preferably 10 to 80 µm, particularly preferably 20 to 50 µm being not less than the thickness of the conductive layer.

The difference in refractive index between an adhesive coating a geometric pattern and a transparent plastic substrate is to be regulated 0.14 or less. In the case where the transparent plastic substrate is layered on a conductive material via the adhesive layer, the difference in refractive index between the adhesive layer and the adhesive coating a geometric pattern is to be regulated 0.14 or less. This is because, when the refractive indexes of the transparent plastic substrate and the adhesive layer, or the refractive indexes of the adhesive and the adhesive layer largely differs, the visible light transmittance is lowered. So long as the difference in refractive index is 0.14 or less, the visible light transmittance is scarcely lowered and thus favorable results can be obtained. In the case of using polyethylene terephthalate (refractive index n=1.575) as the transparent plastic substrate, use can be made, as the adhesive material fulfilling the above requirement, of epoxy resins (refractive indexes: 1.55 to 1.60) such as a bisphenol A type epoxy resin, a bisphenol F type epoxy resin, a tetrahydroxyphenylmethane type epoxy resin, a novolak type epoxy resin, a resorcin type epoxy resin, a polyalcohol polyglycol type epoxy resin, a polyolefin type epoxy resin, an aliphatic or halogenated bisphenol and so on. Examples thereof other than epoxy resins include natural rubber (n=1.52), polyisoprene (n=1.521), poly-1,2-butadiene (n=1.50), polyisobutene (n=1.505 to 1.51), polybutene (n=1.5125), dienes such as poly-2-heptyl-1,3-butadiene (n=1.50), poly-2-t-butyl-1,3-butadiene (n=1.506) and poly-1,3-butadiene (n=1.515), polyoxyethylene (n=1.4563), polyoxypropylene (n=1.495), polyethers such as polyvinyl ethyl ether (n=1.454), polyvinyl hexyl ether (n=1.459) and polyvinyl butyl ether (n=1.4563), polyesters such as polyvinyl acetate (n=1.4665) and polyvinyl propionate (n=1.4665), polyurethane (n=1.5 to 1.6), ethyl cellulose (n=1.479), polyvinyl chloride (n=1.54 to 1.55), polyacrylonitrile (n=1.52), polymethacrylonitrile (n=1.52), polysulfone (n=1.633), polysulfide (n=1.6), a phenoxy resin (n=1.5 to 1.6) and so on. Such a adhesive can exert an appropriate visible light transmittance.

In the case of using an acrylic resin as the transparent plastic substrate, use can be made of, in addition to the resins as cited above, poly(meth)acrylic esters such as polyethyl acrylate (n=1.4685), polybutyl acrylate (n=1.466), poly-2-ethylhexyl acrylate (n=1.463), poly-t-butyl acrylate (n=1.4638), poly-3-ethoxypropyl acrylate (n=1.465), polyoxycarbonyl tetramethylene (n=1.465), polymethyl acrylate (n=1.472 to 1.480), polyisopropyl methacrylate (n=1.4728), polydodecyl methacrylate (n=1.474), polytetradecyl methacrylate (n=1.4746), poly-n-propyl methacrylate (n=1.484), poly-3,3,5-trimethylcyclohexyl methacrylate (n=1.484), polyethyl methacrylate (n=1.485), poly-2-nitro-2-methylpropyl methacrylate (n=1.4868), polytetracarbanyl methacrylate (n=1.4889), poly-1,1-diethylpropyl methacrylate (n=1.4889) and polymethyl methacrylate (n=1.489). If necessary, two or more kinds of these acryl polymers may be copolymerized. It is also possible to use a blend of two or more kinds thereof.

As a resin obtained by copolymerizing an acrylic resin with a resin other than acrylic resins, use can be also made of an epoxy acrylate, a urethane acrylate, a polyether acrylate, a polyester acrylate and so on. From the viewpoint of adhesiveness, an epoxy acrylate and a polyether acrylate are excellent. Examples of the epoxy acrylate include (meth)acrylic acid adducts of 1,6-hexanediol diglycidyl ether, neopentyl glycol diglycidyl ether, allyl alcohol diglycidyl ether, resorcinol diglycidyl ether, diglycidyl adipate, diglycidyl phthalate, polyethylene glycol diglycidyl ether, trimethylolpropane triglycidyl ether, glycerol triglycidyl ether, pentaerythritol tetraglycidyl ether, sorbitol tetraglycidyl ether and so on. Because of having a hydroxyl group in its molecule, an epoxy acrylate is effective in improving adhesiveness. If necessary, two or more kinds of these copolymer resins may be used together. As the main component of the adhesive, use is made of a polymer having a weight-average molecular weight of 1,000 or more. When the molecular weight is less than 1,000, the adhesive has only an insufficient cohesive power and thus the adhesiveness thereof to an adherend is lowered.

As the hardening agent of the adhesive, use can be made of amines such as triethylene tetramine, xylene diamine and diaminodiphenyl methane, acid anhydrides such as phthalic anhydride, maleic anhydride, dodecylsuccinic anhydride, pyromellitic anhydride and benzophenonetetracarboxylic anhydride, diamino diphenyl sulfone, tris(dimethylaminomethyl) phenol, a polyamide resin, dicyanediamide, ethyl methyl imidazole and so on. Either one of these hardening agents or a mixture of two or more kinds thereof may be used. The amount of such a crosslinking agent may be determined within a range of from 0.1 to 50 parts by weight, preferably form 1 to 30 parts by weight, per 100 parts by weight of the polymer as described above. When the hardening agent is added in an amount less than 0.1 part by weight, only insufficient hardening can be achieved. When the amount thereof exceeds 50 parts by weight, on the other hand, there arises an excessive crosslinking, which sometimes adversely affects the adhesiveness. The resin composition to be used as an adhesive in the invention may contain, if necessary, an additive such as a diluent, a plasticizer, an antioxidant, a filler or a tackifier. This resin composition serving as an adhesive is applied so as to entirely or partly coat the constituting substrate having a geometric pattern drawn with the conductive material on the surface of the transparent plastic substrate. After evaporating off the solvent and hardening by heating, an adhesive film according to the invention is obtained. The thus obtained adhesive film, which has both of electromagnetic wave shielding properties and transparency, is utilized by directly bonding, owing to the adhesive contained in the adhesive film, to a CRT, PDP, liquid crystal or EL display. Alternatively, it is bonded to a plate or a sheet such as an acrylic resin plate or a glass plate and then employed in a display. It is also possible to use this adhesion film in an aperture for observing the interior or a housing of a measurement device, a measurement instrument or a production device generating electromagnetic wave in the same manner as described above. Moreover, it may be utilized in a window of a building with a risk of electromagnetic interference by an electrical wave power or a high-voltage cable, an automotive window and so on. It is preferable that the geometric pattern drawn with the conductive material is provided with an earth lead.

A part of the transparent plastic substrate surface, from which the conductive material has been removed, has intentionally formed peaks and valleys for improving adhesiveness or the back face pattern of the conductive material has been transferred thereto. Thus, light scattering on the surface causes a decrease in the transparency. This problem can be overcome by smoothly coating the face having the peaks and valleys with a resin having a refractive index closely similar to the transparent plastic substrate to thereby minimize irregular reflection and exhibit transparency. Because of having an extremely small line width, the geometric pattern drawn with the conductive material on the transparent plastic substrate is invisible to the naked eye. Moreover, the pitch is sufficiently large, which contributes to the exhibition of the apparent transparency. On the other hand, the pitch of the geometric pattern is sufficiently smaller than the wavelength of the electromagnetic wave to be shielded, which seemingly contributes to the exhibition of the transparency.

In the case where a transparent plastic substrate, which is made of a film of an ethylene-vinyl acetate copolymer resin having a high heat fusibility or a highly heat fusible resin such as an ionomer resin, either singly or as a laminate with another resin, is to be laminated on a metal foil, the lamination can be conducted without forming an adhesive layer, as pointed out by JP-A-2003-188576. However, it has been a common practice to carry out the lamination by the dry laminate method with the use of an adhesive layer, etc. Examples of the adhesive constituting the adhesive layer include adhesives comprising an acrylic resin, a polyester resin, a polyurethane resin, a polyvinyl alcohol resin, a vinyl chloride/vinyl acetate copolymer resin, an ethylene/vinyl acetate copolymer resin and so on. Furthermore, use can be made of a thermosetting resin or an ionizing radiation-hardening resin (a ultraviolet hardening resin, an electron beam-hardening resin or the like).

Since a display generally has a glass surface, a transparent plastic film is to be bonded to the glass plate by using a sticky material. Accordingly, there arise various problems such as foaming on the adhesion face or occurrence of peeling, and, in its turn, deformation in an image or a color change from the inherent color to be displayed. The foaming and peeling problems are both caused by the peeling of the sticky material from the plastic film or the glass plate. This phenomenon possibly occurs in both of the plastic film side and the glass plate side. Namely, it occurs in the side having the smaller adhesion force. Therefore, the sticky material should have large adhesion force to both of the plastic film and the glass plate at a high temperature. More specifically speaking, it is preferable that the sticky material has an adhesion force to both of the plastic film and the glass plate of 10 g/cm or more at 80°C, more preferably 30 g/cm or more. However, it is sometimes undesirable to use a sticky material having an adhesion force exceeding 2000 g/cm, since the bonding procedure becomes troublesome in this case, though such a sticky material can be used without any problem in the case being free from the troubles as described above. It is also possible to provide a part of the sticky material, which is not facing to the transparent plastic film, with a paper sheet (a separator) so as to prevent unnecessary contact with other parts.

It is preferable to use a transparent sticky material. More specifically speaking, the total light transmittance of the sticky material is preferably 70% or higher, more preferably 80% or higher and most preferably from 85 to 92%. It is also preferable that the sticky material has a low haze. More specifically speaking, the haze of the sticky material is preferably 0 to 3%, more preferably 0 to 1.5%. To prevent a color change from the inherent color to be displayed, it is preferable that the sticky material to be used in the invention is colorless. However, a sticky material having a small thickness can be substantially regarded as colorless, though the resin per se is colored. Also, the case of intentionally coloring as will be discussed hereinafter is excluded therefrom.

Examples of the sticky material having the characteristics as described above include an acryl-based resin, an α-olefin resin, a vinyl acetate-based resin, an acrylic copolymer-based resin, a urethane-based resin, an epoxy-based resin, a vinylidene chloride-based resin, an ethylene-vinyl acetate-based resin, a polyamide-based resin, a polyester-based resin and so on. Among them, an acryl-based resin is preferred. Even in the case of using a single resin, the sticking property can be improved by, for example, lowering the content of a crosslinking agent to be added in synthesizing the sticky material by the polymerization method, adding a tackifying component, or modifying a terminal group of the molecule. Even in the case of using a single sticky material, furthermore, the adhesiveness can be improved by, for example, surface-modifying the transparent plastic film or the glass plate in the face to be bonded to the sticky material. Examples of the surface-modifying method include physical procedures such as corona discharge and plasma glow processing and the formation of an undercoat layer aiming at improving the adhesiveness.

From the viewpoints of transparency, colorlessness and handling properties, it is preferable that the thickness of the sticky material layer is from about 5 to about 50 µm. In the case of forming the sticky material layer by using an adhesive, the thickness may be lessened within the range as defined above, more specifically, from about 1 to about 20 µm. In the case of causing no change in the display color per se and achieving a transparency falling within the range as defined above, however, the thickness of the layer may exceed the upper limit as defined above.

### <Peelable protective film>

The light transmitting electromagnetic wave shielding film according to the present invention may be provided with a peelable protective film.

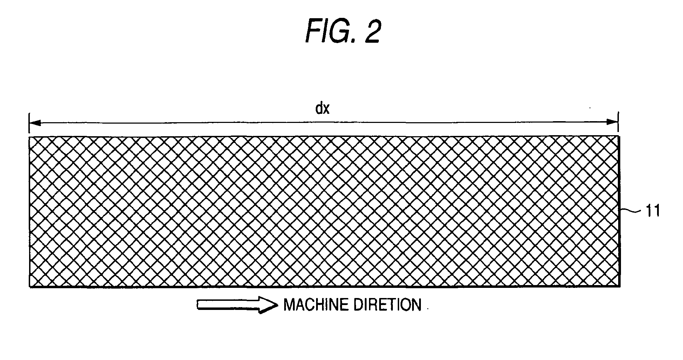

Such protective films are not always provided on both faces of an electromagnetic wave shielding sheet 1 (a light transmitting electromagnetic wave shielding film). As disclosed by JP-A-2003-188576 Fig. 2(a), it is also possible that a protective film 20 is provided exclusively on a mesh-like metal foil 11' of a laminate 10 but not in the side of a transparent base film 14. As disclosed by JP-A-2003-188576 Fig. 2(b), it is also possible that a protective film 30 is provided exclusively in the side of the transparent base film 14 of the laminate 10 but not on the metal foil 11'. In the Figs. 2 and 1 in the patent document as described above, the parts having the same numerical symbol have the same meaning.

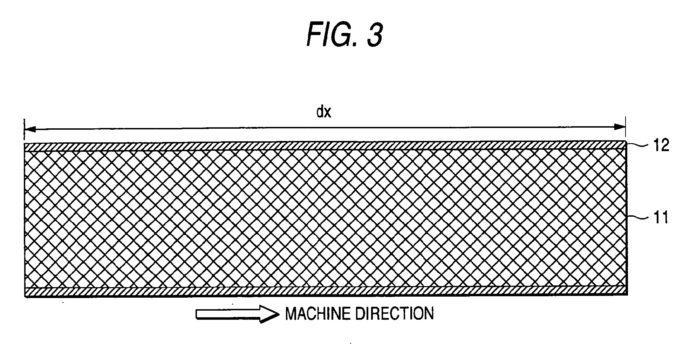

Next, the layer structure of an electromagnetic wave shielding sheet 1 in the form of a laminate, which has at least a transparent base film 14 and an electromagnetic wave shielding layer laminated thereon comprising a mesh-like metal foil 11' in which openings are densely arranged and having a transparency, and a process for producing the laminate will be described by referring to Figs. 3(a) to (f) given in the above-described patent document. Lamination of a protective film 20 and/or a protective film 30 will be described after illustrating the process for producing the laminate.

As shown in Fig. 3(a) in the above patent document, a laminate, which has a transparent base film 14 and a metal foil 11 laminated via an adhesive layer 13, is first prepared. As the transparent base film 14, use can be made of a film made of an acrylic resin, a polycarbonate resin, a polypropylene resin, a polyethylene resin, a polystyrene resin, a polyester resin, a cellulose-based resin, a polysulfone resin or a polyvinyl chloride resin. In general, it is preferable to use a film made of a polyester resin such as a polyethylene terephthalate resin having an excellent mechanical strength and a high transparency. Although the thickness of the transparent base film 14 is not particularly restricted, it preferably ranges from about 50 µm to about 200 µm from the viewpoints of imparting mechanical strength and elevating bending resistance. The thickness may be further increased. In the case of using after laminating an electromagnetic wave shielding sheet 1 on another transparent substrate, it is not always necessary to employ a thickness falling within the range as defined above. If needed, one or both faces of the transparent base film 14 may be subjected to corona discharge processing or an adhesion-facilitating layer may be formed thereon.

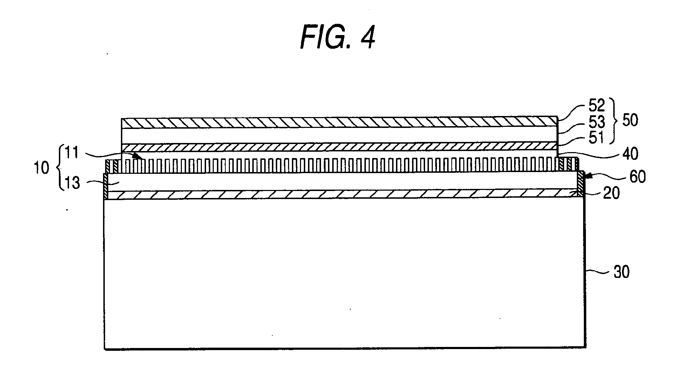

As will be described hereinafter by reference to Fig. 4 in the above-described patent document, the electromagnetic wave shielding sheet 1 is utilized by laminating the above laminate on a substrate via, for example, an infrared-cutting filter layer and further laminating on the front and back faces sheets having effects of strengthening the outermost faces, imparting antireflection properties, imparting antifouling properties and so on. The protective film as described above should be peeled off in the step of the additional lamination. Thus, it is preferable that the protective film is laminated on the metal foil side in a so-called peelable manner.

The peel strength of the protective film laminated on the metal foil is preferably from 5 mN/25 mm width to 5 N/25 mm width, more preferably from 10 mN/25 mm width to 100 mN/25 mm width. A peel strength lower than the lower limit is undesirable, since peeling occurs too easily and, therefore, it is feared that the protective film might peel off during handling or due to an unintended contact in this case. Also, a peel strength exceeding the upper limit is undesirable, since a large force is needed for peeling and it is feared that the mesh-like metal foil might be separated from the transparent base film (or the adhesive layer) upon peeling in this case.

In the electromagnetic wave shielding sheet 1 according to the invention, the protective film laminated in the bottom face side, i.e., the transparent base film side of the laminate, in which the mesh-like metal foil is laminated on the transparent base film 14 via the adhesive layer 13 (optionally having a blackening layer), is employed to protect the lower face of the transparent base film from damages during handling or an unintended contact and to prevent the exposed face of the transparent base film in the individual steps of forming a resist layer on the metal foil and etching, in particular, etching, from contamination or corrosion.

Similar to the protective film as discussed above, this protective film should be peeled off in the step of the additional lamination on the laminate. It is therefore preferable to laminate this protective film in the transparent base film side in a peelable manner. Similar to the above-mentioned protective film, the peel strength preferably ranges from 5 mN/25 mm width to 5 N/25 mm width, more preferably from 10 mN/25 mm width to 100 mN/25 mm width. This is because a peel strength lower than the lower limit is accompanied by a fear that the protective film might peel off during handling or due to an unintended contact because of too easy peeling, while a large force is needed in peeling at a peel strength exceeding the upper limit.

It is preferable that the protective film to be laminated in the transparent base film side is resistant to etching conditions, e.g., not corroding when dipped in an etching solution at about 50°C, in particular, by an alkali component therein, for several minutes. In the case of dry etching, it is preferable that the protective film remains tolerant to a temperature of about 100°C. In the case where the laminate is dip-coated in the step of laminating a photosensitive resin layer, the coating solution sticks to the opposite face too. In this case, therefore, it is preferable that a sufficient adhesion force is achieved between the protective film and the photosensitive resin layer so that the photosensitive resin would not peel off and float in the etching solution. In the case of using an etching solution, it is preferable that the protective film has a tolerance against the contamination with the etching solution containing iron chloride, copper chloride or the like or a tolerance against the corrosion or contamination with a solution for removing resist such as an alkali solution.

To satisfy the requirements as discussed above, it is preferable to use, as the film constituting the protective film, a resin film made of a polyolefin resin such as a polyethylene resin or a polypropylene resin, a polyester resin such as a polyethylene terephthalate resin, a polycarbonate resin, an acrylic resin or the like. From the viewpoints as described above, it is also preferable that at least the face of the protective film serving as the outermost face when applied to the laminate has been subjected to corona discharge processing or an adhesion-facilitating layer has been formed thereon.

As a sticky material constituting the protective film, use can be made of an acrylate-based, rubber-based or silicone-based sticky material.

Such materials of the film for the protective film and for the sticky material are also applicable to the protective film to be applied in the metal foil side. As these protective films, therefore, use can be made of either different films or the same one.

### <Blackening processing>

Referring to the constitutional drawings given in JP-A-2003-188576, the metal foil may have a blackening layer in the transparent base film side so that an antirust effect and antireflection properties can be imparted thereto. The blackening layer, which can be formed by, for example, a Co-Cu alloy plating, can inhibit the reflection on the surface of the metal foil 11. Further, a chromate processing may be conducted thereon as an antirust treatment. The chromate treatment is conducted by dipping the laminate in a solution containing a chromic acid salt or a bichromic acid salt as the main component and drying to thereby form an antirust coating film. If necessary, the chromate treatment can be conducted on one or both faces of the metal foil. Alternatively, use may be made of, for example, a commercially available copper foil having been subjected to the chromate treatment. In the case where a blackened metal foil is not used, the blackening processing may be conducted later at an appropriate step. The blackening layer may be formed by forming a photosensitive resin layer, which can serve as a resist layer as will be discussed hereinafter, by using a composition in a black color and, after the completion of the etching, allowing the resist layer to remain without removing. Alternatively, it may be formed by a plating method whereby a black coating film can be formed.

An example of the constitution including a blackening layer may be the constitution reported by JP-A-11-266095. In the electromagnetic wave shielding plate as described above, for example, blackening layers composed of a first blackening layer 3a, a second blackening layer 3b and so on, which constitute a mesh-like conductive pattern P having a line x in a lateral direction and a line y in a vertical direction crossed each other, can be formed by an appropriately selected method based on the following principle. In the present invention, there are two methods for forming the mesh-like conductive pattern P that is the main object, i.e., the metal plating method and the etching method. In the invention, the method and materials for forming the first blackening layer 3a, the second blackening layer 3b, etc. differ depending on the selected method. In the case of forming the conductive pattern P on the first blackening layer 3a, the second blackening layer 3b, etc. by the metal plating method in the invention, a conductive blackening layer that can be processed by metal plating should be employed. In the case of blackening the layer by the etching method or the electrodeposition method at the final stage, on the other hand, it is possible to form a nonconductive blackening layer by using a nonconductive material. The conductive blackening layer can be formed generally by using a conductive metal compound such as a compound of nickel (Ni), zinc (Zn) or copper (Cu). The nonconductive blackening layer can be formed by using, for example, a pasty black polymer material such as a black ink, a black chemical material such as a black compound prepared by chemically treating a metal plated surface or an electrodepositable ionic polymer material such as an electrodepositable coating material. In the present invention, a blackening layer can be formed by using such a blackening layer-formation method and appropriately selecting a method suitable for the production process of producing the electromagnetic wave shielding plate.

In the invention, it is preferable that the conductive patterned face is located as the opposite face of the conductive metal part to the PDP module, namely, the face visible from the side of observing the PDP as a TV or the like. To elevate the contrast in observation, it is preferable that the conductive patterned face is in a black color. When a part having a black color amounts to 20% or more of the total surface area of the conductive patterned face, the contrast can be elevated. The expression "20% or more" as used herein means that the black part consists of minor sections being almost invisible and the total area of these sections amounts to 20% or more of the total surface area of the conductive patterned face. It is preferable that a part having a black color amounts to 50% or more of the total surface area of the conductive patterned face and more preferably 80% or more. It is also preferred to form a black layer on the surface opposite to the side of observing as a TV, etc.

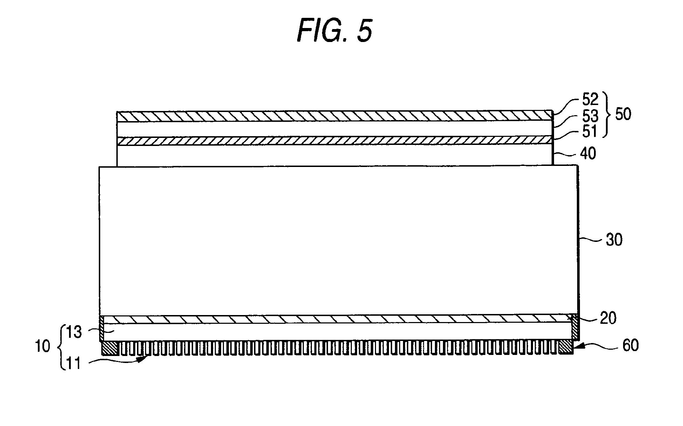

As shown in Fig. 5 in JP-A-11-266095, a method for forming the blackening layer comprises first dipping an electrodepositable substrate 14, which has a mesh-like resist pattern 12 comprising an insulating film preventing electrodeposition on a conductive substrate 11 such as a metal plate formed above, in an electrolyte such as blackened copper or blackened nickel, and conducting plating by a known electrochemical plating method to thereby form a mesh-like second blackening layer 3b comprising a blackened copper layer or a blackened nickel layer. As the black plating bath as described above, it is possible in the invention to use a black plating bath containing nickel sulfate as the main component. Also, use can be made of a commercially available black plating bath. Specific examples usable herein include a black plating bath (trade name: NOBUROI SNC, Sn-Ni alloy base) manufactured by Shimizu Co., Ltd., a black plating bath (trade name: NIKKA BLACK, Sn-Ni alloy base) manufactured by NIHON KAGAKU SANGYO Co., Ltd.), a black plating bath (trade name: EBONY CHROM 85 SERIES, Cr-base) manufactured by KINZOKU KAGAKU KOGYO K.K. and so on. As the black plating bath, use can be made of various black plating baths including Zn-based and Cu-based ones. In the invention, similar to Fig. 5 in the above-described document, the electrodepositable substrate 14 having the second blackening layer 3b formed thereon is dipped in a metal electrolyte for shielding electromagnetic wave. Thus, a mesh-like conductive pattern 4 having a desired thickness is laminated and electrodeposited on the part corresponding to the second blackening layer 3b of the electrodepositable substrate 14. As the material for forming the mesh-like conductive pattern 4, such a metal as cited above as highly conductive materials can be used as the most advantageous material. In the case of thus forming the electrodeposited metal layer, use can be made of a metal electrolyte commonly employed in the art. Since there are many kinds of inexpensive metal electrolytes, this case is advantageous in that a metal electrolyte appropriate for the purpose can be freely selected. As an inexpensive and highly conductive metal, Cu has been frequently used in general. Although Cu is usable in the invention too, it is needless to say that another metal is also usable so long as being appropriate for the purpose and useful. In the invention, it is not always necessary that the mesh-like conductive pattern 4 consists of a single metal layer alone. Since a mesh-like conductive pattern P made of Cu as described above is relatively soft and liable to suffer from scuff marks, it is also possible to form a double-layered metal electrodeposited layer using a hard metal commonly employed such as Ni or Cr, though such a case is not shown in the drawing. As Fig. 5 shows, after forming the mesh-like conductive pattern 4 in the invention, the surface of the mesh-like conductive pattern 4 is chemically treated. In the case where the conductive pattern P is made of copper (Cu), for example, the mesh-like conductive pattern 4 is surface-treated with a hydrogen sulfide (H₂S) solution to blacken the copper surface as copper sulfide (CuS). Thus, the surface of the metal electrodeposited layer constituting the mesh-like conductive pattern 4 is blackened to form the first blackening layer 3a. Subsequently, the above-described second blackening layer 3b, the conductive pattern layer 4 and the first blackening layer 3a are successively laminated in this order to give the mesh-like conductive pattern P. In the invention, the blackening treatment of the copper surface as described above can be easily conducted by using a sulfide compound or a sulfide-based compound. Alternatively, there are many kinds of commercially available treating agents such as COPPER BLACK CuO, COPPER BLACK CuS, selenium-based COPPER BLACK No.65, etc. (trade names; manufactured by ISOLATE KAGAKU KENKYUSHO) and EBONOL C SPECIAL (trade name; manufactured by MELTEX Inc.) which can be also employed in the invention.

In the electromagnetic wave shielding plate as described above, an etching resist pattern 35 may be either removed or allowed to remain. In the case of removing the etching resist pattern 35, it is possible that, after removing the etching resist pattern 35, the surface of the remaining conductive metal layer 33 is blackened. For the blackening treatment, use can be made of a publicly known blackening method such as the plating method using, for example, black copper (Cu) or black nickel (Ni) or the chemical blackening method.

### [Optical filter]

The optical filer according to the invention may have a functional film provided with complex functional layers, in addition to the light transmitting electromagnetic wave shielding film as described above.

### <Complex functional layer>

In a display, extraneous images caused by the reflection of a lighting apparatus, etc. interferes the viewing of the display screen. Thus, a functional film (C) should have either antireflective (AR) properties of preventing the reflection of outside light, antiglare (AG) properties of preventing mirror reflection or antireflective and antiglare (ARAG) properties satisfying both of these requirements. A low visible light reflectivity of an optical filter surface contributes not only to the prevention of the reflection of outside light but also to an improvement in contrast and so on.

A functional film (C) having antireflective properties has an antireflective film. More specifically speaking, the antireflective film has a low refractive index in the visible region of 1.5 or less, preferably 1.4 or less and is prepared by forming a single layer of a thin film made of a fluoropolymer resin, magnesium fluoride, a silicone-based resin or silicon oxide at, for example, a 1/4 wavelength optical film thickness, or laminating multiple layers of thin films having different refractive indexes and being made of an inorganic compound such as a metal oxide, a fluoride, a silicide, a nitride or a sulfide or an organic compound such as a silicone-based resin, an acrylic resin or a fluorinated resin, though the invention is not restricted thereto. The visible light reflectivity of the functional film (C) having antireflective properties is 2% or less, preferably 1.3% or less and more preferably 0.8% or less.

A functional film (C) having antiglare properties has an antiglare film having small peaks and valleys of about 0.1 µm to about 10 µm on the surface and being transparent to visible light. More specifically speaking, such a functional film is produced by dispersing grains of an inorganic compound or an organic compound such as silica, an organic silicon compound, melamine or acryl in a thermosetting or photosetting resin such as an acrylic resin, a silicone-based resin, a melamine-based resin, a urethane-based resin, an alkyd-based resin or a fluorinated resin to give an ink, and then coating the ink on the substrate followed by hardening. The average diameter of the grains is 1 to 40 µm. Alternatively, antiglare properties can be achieved by coating the thermosetting or photosetting resin on the substrate and pressing a mold having a desired gloss or surface conditions against it followed by hardening. However, the invention is not restricted to these methods. The haze of the functional film (C) having antiglare properties is 0.5% or more but not more than 20%, preferably 1% or more but not more than 10%. When the haze is too low, only insufficient antiglare properties can be obtained. At an extremely high haze, on the other hand, the sharpness of a transmission image is liable to be lowered.

To impart a sufficient scratch resistance to the optical filter, it is favorable that the functional film (C) has hard coat properties. A hard coat film may be formed by using, for example, a thermosetting or photosetting resin such as an acrylic resin, a silicone-based resin, a melamine-based resin, a urethane-based resin, an alkyd-based resin or a fluorinated resin, though neither the material nor the formation method is particularly restricted. The thickness of such a film is form about 1 to about 50 µm. The pencil hardness determined in accordance with JIS (K-5400) of the functional film (C) having hard coat properties is at least H, preferably 2H and more preferably 3H or more. It is favorable to form an antireflective film and/or an antiglare film on the hard coat film, since a functional film (C) having a scratch resistance, antireflective properties and/or antiglare properties can be thus obtained.

Dusts and debris frequently stick to an optical filter due to electrostatic charge. When being in contact with the human body, an optical filter sometimes causes an electrical shock due to discharge. Therefore, it is sometimes required to conduct an antistatic treatment. To impart antistatic properties, a functional film (C) may have conductivity. The conductivity required in this case may be about 10¹¹ Ω/□ or less expressed in surface resistivity. As a method of imparting conductivity, there can be enumerated a method of adding an antistatic agent to the film or a method of forming a conductive layer. Specific examples of the antistatic agent include PELLESTAT (trade name; manufactured by SANYO CHEMICAL INDUSTRIES, Ltd.), ELECTROSLIPPER (trade name; manufactured by KAO) and so on. Examples of the conductive layer include publicly known transparent conductive films typified by ITO and conductive films having conductive micrograins such as ITO micrograins or tin oxide micrograins dispersed therein. It is favorable that the hard coat film, the antireflective film or the antiglare film is provided with a conductive film or contains conductive micrograins.

It is preferable that the surface of the functional film (C) has antifouling properties, since fouling with finger prints or the like can be prevented and foulings, if any, can be easily removed thereby. As an antifouling agent, use can be made of a substance having no wetting characteristics to water and/or fat and oil, for example, a fluorine compound or a silicon compound. Specific examples of the fluorine-containing antifouling agent include OPTOOL (trade name; manufactured by DAIKIN INDUSTRIES, Ltd.) and so on, while specific examples of the silicon compound include TAKATAQUANTUM (trade name; manufactured by NOF Co.) and so on. It is favorable to employ such an antifouling layer in the antireflective film, since an antifouling antireflective film can be thus obtained.

To prevent a dye and a polymer film, as will be described hereinafter, from deterioration, it is preferable that the functional film (C) has ultraviolet-blocking properties. Such a functional film (C) having ultraviolet-blocking properties can be obtained by adding a ultraviolet absorber to the polymer film as discussed above or imparting a ultraviolet absorption film thereto.

When an optical filter is used in an environment at a temperature higher than room temperature or a humidity higher than ordinary humidity, it is sometimes observed that a dye as will be described hereinafter is deteriorated due to moisture permeating through a film, clouding arises due to moisture aggregation in a sticky material employed in bonding or the bonding interface, or a tackifier, etc. in the sticky material undergoes phase separation under the effect of moisture to thereby cause clouding. It is therefore preferable that the functional film (C) has gas-barrier properties. To prevent the dye denaturation or clouding, invasion of water into a dye-containing layer or the sticky material layer should be prevented. For this purpose, it is appropriate that the vapor transmission of the functional film (C) is 10 g/m² day or less, preferably 5 g/m² day or less.

In the present invention, the polymer film (A), the conductive mesh layer (B), the functional film (C) and a transparent molded article (E), which may be employed if needed as will be described hereinafter, are bonded with the use of an arbitrary sticky material or adhesive (D1) (D2) transparent to visible light. Specific examples of the sticky material or adhesive (D1) (D2) include a polyether, a saturated amorphous polyester, a melamine resin and so on such as an acrylic adhesive, a silicone-based adhesive, a urethane-based adhesive, a polyvinyl butyral (PVB) adhesive and ethylene-vinyl acetate (EVA)-based adhesive. Such a sticky material or adhesive may be either a sheet or a liquid, so long as it has a practically acceptable adhesion strength. As the sticky material, use can be preferably made of a pressure-sensitive adhesive in the form of a sheet. After bonding a sheet type sticky material or coating an adhesive, bonding is conducted by laminating the individual members. After coating and bonding, a liquid type adhesive hardens by allowing to stand at room temperature or heating. Examples of the coating method include the bar coating method, the reverse coating method, the gravure coating method, a die coating method, a roll coating method and so on. An appropriate method may be selected depending on the kind, viscosity, coating amount, etc. of the adhesive. Although the thickness thereof is not particularly restricted, it ranges from 0.5 µm to 50 µm, preferably from 1 µm to 30 µm. It is favorable that the face on which the sticky material layer is to be formed and the face to be bonded thereto are preliminarily subjected to an adhesion-facilitating treatment such as coating with an adhesion accelerator or corona discharge so as to improve the wetting characteristics. In the present invention, such a sticky material or adhesive transparent to visible light as discussed above is called a light transmitting sticky material.

When the functional film (C) is bonded on the conductive mesh layer (B) in the invention, a light transmitting sticky material layer (D1) is employed. Specific examples of the light transmitting sticky material to be used in the light transmitting sticky material layer (D1) are the same as those cited above. It is important that the thickness of this layer sufficiently compensates for the depth of the valleys in the conductive mesh layer (B). In the case where the thickness of this layer is smaller than the thickness of the conductive mesh layer (B), the compensation cannot be sufficiently made and bubbles invade into the valleys. As a result, the thus obtained display filter becomes cloudy and has only an insufficient light transmittance. In the case where the thickness of this layer is too large, on the other hand, there arise some problems such as an increase in the production cost of the sticky material and worsening in handling. When the conductive mesh layer (B) has a thickness of d µm, it is preferable that the thickness of the light transmitting sticky material layer is (d-2) to (d+30) µm.

It is preferable that the visible light transmittance of the optical filter is from 30 to 85%, more preferably form 35 to 70%. When the visible light transmittance is less than 30%, the luminance is excessively lowered and the visibility is worsened. In the case where the visible light transmittance of the optical display is too high, the contrast of the display cannot be improved. The visible light transmittance in the present invention is calculated in accordance with JIS(R-3106) based on the wavelength-dependency of transmittance in the visible light region.

When functional film (C) is bonded to the conductive mesh layer (B) via the light transmitting sticky material layer (D1), it is sometimes observed that bubbles invade into the valleys and cause clouding, thereby lowering light transmitting properties. In this case, the light transmitting properties can be improved by degassing the bubbles having invaded between the members by pressurizing or solid-dissolving the bubbles in the sticky material to thereby get off the cloudiness. The pressurization may be conducted in the state of the constitution (C)/(D1)/(B)/(A). Alternatively, the display filter according to the invention may be subjected to the pressurization.

Examples of the method of the pressurization include a method comprising sandwiching the laminate between flat plates and pressing, a method comprising passing the laminate between nip rolls under elevated pressure and a method comprising putting the laminate into a pressurized container followed by pressurization, though the invention is not particularly restricted thereto. The method of pressurizing in a pressurized container is favorable, since pressure can be uniformly applied to the whole laminate without unevenness and multiple laminate sheets can be treated at the same time. As the pressurized container, use can be made of an autoclave.

Concerning the pressurization conditions, the invading bubbles can be removed at a higher efficiency and the treatment can be shortened under a higher pressure. Considering the restriction due to the pressure proofness of the laminate and the pressurization apparatus, the pressure is from about 0.2 MPa to about 2 MPa, preferably from 0.4 to 1.3 MPa. The pressurization time varies depending on the pressurization conditions without restriction. An excessively long pressurization time results in an increase in cost. It is therefore favorable to conduct the pressurization under appropriate conditions over a retention time of 6 hours or shorter. In the case of using a pressurized container, it is particularly appropriate to maintain the intended pressure level for about 10 minutes to about 3 hours.

It is preferable in some cases to conduct heating together with the pressurization. Heating causes a temporary increase in the flowability of the light transmitting sticky material and thus facilitates degassing or promotes the dissolution of the bubbles in the sticky material. Heating may be conducted at room temperature to not higher than about 80°C depending on the heat tolerance of each member constituting the optical filter, though the invention is not particularly restricted thereby.

The pressurization or heating treatment is favorable, since it can improve the adhesion force after bonding the individual members constituting the optical filter.

In the optical filter according to the invention, another light transmitting sticky material layer (D2) is formed on the other main face, on which the conductive mesh layer (B) is not formed, of the conductive mesh layer (B) of the polymer film (A). Specific examples of the light transmitting sticky material layer (D2) are the same as those cited above and the invention is not particularly restricted thereby. Although the thickness thereof is not particularly restricted, it ranges from 0.5 µm to 50 µm, preferably from 1 µm to 30 µm. It is favorable that the face on which the light transmitting sticky material layer (D2) is to be formed and the face to be bonded thereto are preliminarily subjected to an adhesion-facilitating treatment such as coating with an adhesion accelerator or corona discharge so as to improve the wetting characteristics.

A release film may be formed on the light transmitting sticky material layer (D2). That is to say, the laminate is at least composed of the functional film (C)/the light transmitting sticky material layer (D1)/the conductive mesh layer (B)/the polymer film (A)/the light transmitting sticky material layer (D2)/the release film. The release film is prepared by coating the main face of a polymer film, which is to be in contact with the sticky material, with silicone or the like. In bonding the optical filter according to the invention to the main face of a transparent molded article (E) as will be described hereinafter, or in the case of bonding it to the display surface such as the front glass face of a plasma display panel, the release film is peeled off to thereby expose the light transmitting sticky material layer (D2) followed by bonding.

The optical filter according to the invention is utilized mainly for blocking electromagnetic wave generated from various displays. As a preferable example thereof, a filter for a plasma display may be cited.

Since a plasma display generates strong near infrared rays as mentioned above, the optical filter should block not only electromagnetic wave but also near infrared rays to such an extent as causing no problem in practice. Thus, it is necessary to regulate the transmittance in the wavelength region of from 800 to 1000 nm to 25% or less, preferably 15% or less and more preferably 10% or less. An optical filter to be used in a plasma display should have a transmission color of neutral gray or blue gray. This is because it is necessary to maintain or improve the light emission characteristics and contrast of the plasma display and a white color with a somewhat higher color temperature than the standard white color is preferred in some cases. It is said that a color plasma display has only insufficient color reproducibility. It is therefore preferable to selectively lower unnecessary light emission from a fluorescent body or discharged gas causing the above problem. In particular, a light emission spectrum in red display shows several emission peaks in a wavelength range of about 580 nm to about 700 nm and there arises a problem that red light emission becomes close to an orange color with a low color purity due to a relatively strong emission peak in the short wavelength side. These optical characteristics can be controlled by using a dye. Namely, near infrared rays can be cut by using a near infrared absorber while unnecessary light emission can be reduced by using a dye capable of selectively absorbing the unnecessary light emission, thereby achieving desired optical characteristics. It is also possible to achieve a favorable color tone of the optical filter by using a dye having an appropriate absorption within the visible region.

A dye may be contained by using one or more methods selected from: (1) using a polymer film or a resin plate produced by kneading one or more kinds of dyes with a transparent resin; (2) using a polymer film or a resin plate produced by the casting method by dispersing or dissolving one or more kinds of dyes in a thick resin solution comprising a resin monomer/an organic solvent; (3) using a polymer film or a resin plate coated with a coating produced by adding one or more kinds of dyes and a resin binder to an organic solvent; and (4) using a transparent sticky material containing one or more kinds of dyes; though the invention is not restricted thereto. The term "contained" as used herein means not only being contained in a base, a layer such as a coating film or a sticky material but also being coated on the surface of a base or a layer.

The dye as described above may be a commonly employed dye or pigment having a desired absorption wavelength in the visible region or a near infrared absorber and the kind thereof is not particularly restricted. Examples thereof include commonly marketed organic dyes such as anthraquinone, phthalocyanine, methine, azomethine, oxazine, imonium, azo, styryl, coumarine, porphyline, dibenzofuran, diketopyrropyrrole, rhodamine, xanthene, pyrromethene, dithiol and diimonium compounds. The kind and concentration of the dye are determined depending on the absorption wavelength and absorption coefficient of the dye, the transmission properties and transmittance required as an optical filter and the kind and thickness of a medium or a coating film in which it is to be dispersed, without particular restriction.

In a plasma display panel having a high surface temperature and being employed at a high environmental temperature, the optical filter temperature is also elevated. Therefore, it is preferable that the dye has such a heat resistance as not being seriously deteriorated by, for example, decomposition at 80°C. In addition to the heat resistance, some dyes are less resistant to light. When there arises the problem of deterioration caused by the light emission from a plasma display panel or ultraviolet light or visible light in the outside light, it is required to relieve the deterioration of a dye due to ultraviolet light by using a member containing a ultraviolet absorber or a ultraviolet -blocking member or use a dye suffering from no serious deterioration caused by ultraviolet light or visible light. In addition to heat and light, the same applies to humidity and an environment having a combination of these factors. When a dye is deteriorated, the transmission characteristics of a display filter are changed and thus the color tone thereof is changed or the ability to block near infrared rays is lowered. Since a dye is to be dispersed in a medium or a coating film, the solubility or dispersibility in an adequate solvent is also an important factor. In the invention, two kinds or more dyes having different absorption wavelengths may be contained in a single medium or coating film. It is also possible to provide two or more dye-containing media or coating films.

In the present invention, the methods (1) to (4) for containing a dye are usable in the optical filter according to the invention in one of the following modes, namely, a dye-containing polymer film (A), a dye-containing functional film (C), a dye-containing light transmitting sticky materials (D1) and (D2), and another dye-containing light transmitting sticky material or adhesive to be used in bonding.

In general, a dye is liable to be deteriorated by ultraviolet light. The ultraviolet light, to which an optical filter is exposed under usual working conditions, is involved in outside light such as sunlight. To prevent the deterioration caused by ultraviolet light, it is appropriate that at least one layer selected from the dye-containing layer per se and a layer located in the viewer's side exposed to the outside light is provided with a layer capable of blocking ultraviolet light. In the case where the polymer film (A) contains a dye, for example, the dye can be protected from the outside light involving ultraviolet light by adding a ultraviolet absorber or providing a functional film capable of blocking ultraviolet light to the sticky material layer (D1) and/or the functional film (C). To block ultraviolet light for protecting a dye, the transmittance in the ultraviolet region of wavelength shorter than 380 nm should be 20% or less, preferably 10% or less and more preferably 5% or less. A functional film capable of blocking ultraviolet light may be either a coating film containing a ultraviolet absorber or an inorganic film reflecting or absorbing ultraviolet light. As the ultraviolet absorber, use can be made of a publicly known one such as a benzotriazole or benzophenone compound. The kind and concentration thereof are determined based on the dispersibility or solubility in a medium in which it is to be dispersed or dissolved, the absorption wavelength, the absorption coefficient, the thickness of the medium and so on, without particular restriction. It is preferable that the layer or film capable of blocking ultraviolet light has small absorption in the visible region and causes neither a large decrease in the visible light transmittance nor coloration such as yellowing. In the case where a dye-containing layer is formed in the dye-containing functional film (C), a layer or a functional film located in the viewer's side of the layer may have the ability to block ultraviolet light. In the case where the polymer film contains a dye, it may have a functional film or a functional layer capable of blocking ultraviolet light in the viewer's side of the film.

Some dyes would be deteriorated due to contact with a metal. In the case of using such a dye, it is more preferable to locate the dye in such a manner as minimize the contact thereof with the conductive mesh layer (B). More specifically speaking, it is preferable that the dye-containing layer is the functional film (C), the polymer film (A) or the light transmitting sticky material layer (D2), and the light transmitting sticky material layer (D2) is particularly preferable.

The optical filter according to the present invention consists of the polymer film (A), the conductive mesh layer (B), the functional film (C), the light transmitting sticky material layer (D1) and the light transmitting sticky material layer (D2) in the order of (C)/(D1)/(B)/(A)/(D2). It is preferable that a conductive mesh film consisting of the conductive mesh layer (B) and the polymer film (A) is bonded to the functional film with the use of the light transmitting sticky material layer (D1) and the light transmitting sticky material layer (D2) is provided on the main face of the polymer film (A) opposite to the conductive mesh layer (B).

To mount the optical filter of the invention on a display, the functional film (C) is located in the viewer's side while the light transmitting sticky material layer (D2) is located in the display side.

As a method of using the optical filter of the invention in the front face of a display, there can be enumerated a method wherein the optical filter is employed as a front face filter using a transparent molded article (E), which will be described hereinafter, as a support, and another method wherein the optical filter is bonded to the display surface via the light transmitting sticky material layer (D2). The former method is suitable for protecting the display, since the optical filter can be relatively easily provided and the mechanical strength is elevated owing to the support. In the latter method, on the other hand, it is advantageous that the weight and thickness can be reduced because of the absence of a support and the reflection on the display surface can be prevented.

Examples of the transparent molded article (E) include a glass plate and a light transmitting plastic plate. From the viewpoints of mechanical strength, lightness and non-fragileness, a plastic plate is preferred. However, it is also preferable to use a glass plate which is stable to heat and undergoes little deformation by heat. Specific examples of the plastic plate include those made of an acrylic resin such as methyl polymethacrylate (PMMA), a polycarbonate resin and a transparent ABS resin, though the invention is not restricted to these resins. It is particularly appropriate to use PMMA which sustains a high transparency and a high mechanical strength over a broad wavelength region. The thickness of the plastic plate is not particularly restricted, so long as it has a sufficient mechanical strength and such a rigidity as keeping planarity without sagging. In general, the thickness is about 1 mm to about 10 mm. As the glass plate, it is preferable to use a semihardened glass plate or a hardened glass plate having been subjected to a chemical hardening processing or an air-cooling hardening processing so as to impart mechanical strength. Considering weight, the thickness of the glass plate is preferably from about 1 to about 4 mm, though the invention is not restricted thereto. Before bonding to the film, the transparent molded article (E) may be subjected to various known pretreatments. It is also possible to conduct colored (for example, black) frame printing in the part serving as the periphery of the optical filter.

In the case of using the transparent molded article (E), the optical filter consists at least of the functional film (C)/the light transmitting sticky material layer (D1)/the conductive mesh layer (B)/the polymer film (A)/the light transmitting sticky material layer (D2)/the transparent molded article (E). It is also possible to form, via a light transmitting sticky material layer, a functional film (C) on the main face of the transparent molded article (E) opposite to the face to be bonded to the light transmitting sticky material layer (D2). In this case, it is not necessary that this functional film has the same function or constitution as the functional film (C) provided in the viewer's side. In the case where this functional film has antireflective properties, for example, the back face reflection of the optical filter having the support can be reduced. Also, it is possible to form a functional film (C2) such as an antireflective film on the main face of the transparent molded article (E) opposite to the face to be bonded to the light transmitting sticky material layer (D2). Although the functional film (C2) may be located in the viewer's side of the display in this case, it is preferable to provide a layer capable of blocking ultraviolet light in the dye-containing layer or in the viewer's side of the dye-containing layer as described above.

In an instrument with a need for electromagnetic wave shielding, it is required to block electromagnetic wave by forming a metal layer in the case of the instrument or using a conductive material as the case. When a transparent indication part is needed as in a display, a window-shaped electromagnetic wave shielding filter having a light transmitting conductive layer, such as the optical filter of the invention, is provided. Electromagnetic wave is absorbed by the conductive layer and then induces electrical charge. Unless the charge is cut off by earthing, the optical filter serves as antenna again and oscillates electromagnetic wave, thereby causing a decrease in the electromagnetic wave shielding ability. Therefore, the optical filter should be in electrical contact with the earthing part of the display body. Thus, the light transmitting sticky material layer (D1) and the functional film (C) as described above should be formed on the conductive mesh layer (B) while leaving a conduct part allowing conduction to the outside. Although the conduct part is not particularly restricted in shape, it is necessary that there is no gap allowing the leakage of electromagnetic wave between the optical filter and the display body. It is therefore adequate that the conduct part is continuously formed in the periphery of the conductive mesh layer (B). Namely, it is preferable that a frame-like conductive part is provided excluding the center serving as the indication part of the display.

The conduct part may be either a mesh pattern layer or a non-patterned layer such as a solid metal foil layer. To achieve favorable electrical conduct with the earthing part of the display body, however, a non-patterned conduct part such as a solid metal foil layer is preferred.

It is appropriate that the conduct part is non-patterned such as a solid metal foil and/or the conduct part has a sufficiently high mechanical strength, since the conduct part is usable as an electrode as such.

To protect the conduct part and/or to achieve favorable electrical conduct with the earthing part in the case where the conduct part is a mesh pattern layer, it is sometimes preferable to form an electrode in the conduct part. Although the electrode is not particularly restricted in shape, an electrode entirely covering the conduct part is preferred.

From the viewpoints of conductivity, corrosion resistance and adhesiveness to a transparent conductive film, examples of the material to be used for the electrode include pastes of metals such as silver, copper, nickel, aluminum, chromium, iron, zinc and carbon, which may be used either singly or as an alloy of two or more kinds thereof, mixtures of such metals (either singly or as an alloy) with a synthetic resin, and mixtures comprising borosilicate glass with such metals (either singly or as an alloy). To print and coat such a paste, use can be made of a publicly known method. Moreover, a marketed conductive tape is appropriately usable. As a conductive tape, use can be made of either a tape having conductivity in both faces or a single-side adhesive type using a conductive adhesive of the carbon dispersion type. A tape of the double-faced adhesive type is preferably employed. The thickness of the electrode is several µm to several mm, though the invention is not restricted thereto.

According to the present invention, it is possible to obtain an optical filter having excellent optical characteristics whereby the image qualities of a plasma display can be maintained or even improved without largely damaging the luminance thereof. It is also possible thereby to obtain an optical filter being excellent in the electromagnetic wave shielding ability to block electromagnetic wave generated from a plasma display, which has been pointed out as possibly exerting adverse effects on the health, being capable of efficiently blocking near infrared beams of about 800 to about 1000 nm generated from the plasma display without adversely affecting wavelengths employed by peripheral devices such as a remote control, transmitting optical communication systems and so on, and thus making it possible to prevent mechanical errors thereof. It is furthermore possible to provide an optical filter also having an excellent weatherability at a low cost.

Next, a method of producing a display filter for achieving the second object of the present invention as described above will be illustrated in greater detail.

The method of producing a display filter according to the present invention is characterized by using an electromagnetic wave shielding material (C) wherein a conductive layer (B) formed on one face of a polymer film (A), which has a mesh pattern continuously formed in the machine direction of the polymer film (A), and comprising the step of cutting the mesh-like parts of the electromagnetic wave shielding material (C) in the course of the production.

The polymer film (A) may be a film allowing the transmission of light in the visible region. In the present invention, the term "transparent" means allowing the transmission of light in the visible region. Specific examples of the polymer film (A) include polyethylene terephthalate, polyether sulfone, polystyrene, polyethylene napthalate, polyarylate, polyether ether ketone, polycarbonate, polyethylene, polypropylene and so on, though the invention is not restricted thereto. Such a polymer film may have a hard coat layer or the like. Before forming the conductive mesh layer (B), it is also possible to subject the polymer film (A) to various known pretreatments such as washing or corona discharge. The thickness of the polymer film (A) is preferably 10 to 250 µm, though the invention is not restricted thereto.

To form the conductive layer (B) on the polymer film (A), a publicly known method may be employed. Examples of the method include: (a) a method which comprises forming a geometric pattern with a conductive substance (B1) on one face of the polymer film (A) and then attaching a conducive substance (B2) to this geometric pattern; (b) a method comprising bonding the polymer film (A) to a metal foil (B4)via an adhesive layer (B3) and then processing the metal foil (B4) to give a geometric pattern; and so on.

Examples of the method of forming a geometric pattern with the conductive substance (B1) in the method (a) include: a method of directly printing the conductive substance (B1) on once face of the polymer film (A) by ink jetting, intaglio printing, relief printing, planographic printing, screen printing, etc.; a method of coating or laminating the polymer film (A) with the photosensitive conductive substance (B1), forming the pattern by, for example, exposure to laser drawing and then removing an exposed part or an unexposed part; and so on. As examples of the method of attaching the conductive substance (B2) on the geometric pattern formed by the conductive substance (B1), publicly known methods such as electroless plating and electrolytic plating may be cited. In the case where the geometric pattern formed by using the conductive substance (B1) has a sufficient conductivity, it can be used as such as an electromagnetic wave shielding material without attaching the conductive substance (B2). As a specific example, there can be presented a method which comprises coating an emulsion containing a silver halide on the polymer film (A), conducting scanning exposure by the laser drawing method so as to give a continuous mesh shape, conducting development so as to form a metalized silver area and a light transmitting area, and then conducting electroless plating with the use of copper sulfate to thereby form a mesh-patterned conductive layer.

In the method (b), on the other hand, a geometric patterns is formed on the metal foil (B4) by using a method which comprises printing a resist pattern such as ink jetting, intaglio printing, relief printing, planographic printing, screen printing, etc. or a method which comprises coating a photosensitive resist on the metal foil (B4), exposing by the laser drawing method or the like, then conducting development to thereby form a resist pattern and eluting the metal in a part other than the pattern with an appropriate etching solution to thereby form the desired conductive layer (B). As a specific example, there can be cited a method which comprises bonding a copper foil to a polymer film via a urethane-based adhesive layer, continuously forming a mesh-like resist pattern on the copper foil by gravure printing, drying, removing the copper foil in a non-resist part by using an etching solution comprising, for example, ferric chloride, washing with water and then peeling off the resist by using an alkali.

The method of forming the conductive layer (B) on the polymer film (A) is not restricted to the method (a) or (b) as described above. However, it is preferable to employ the method (a) wherein a layer lowering the transparency of the light transmitting area (such as the adhesive layer (B3) in the method (b)) is not formed. In addition to the methods (a) and (b), there can be enumerated further examples of the method of forming the conductive layer (B), i.e., (c) a method which comprises forming a mesh-like conductive thin metal film and then transferring this mesh-like conductive thin metal film to the polymer (A) to give the conductive layer (B); and (d) a method which comprises forming a transparent resin layer showing high adhesiveness to a metal on the polymer film (A), further forming a thin metal film layer by electroplating, dry coating or the like, forming a resist pattern in the same manner as in the method (b), and removing the thin metal film layer in the non-resist pattern part by etching to thereby give the conductive layer (B).

The thickness of the conductive layer (B) is determined depending on the required electromagnetic wave shielding properties, light transmittance and the method employed in forming the conductive layer (B). Although the conductivity required in shielding electromagnetic wave in a plasma display panel varies depending on electromagnetic wave standards and the intensity of the electromagnetic wave generated from the plasma display panel, it preferably ranges from 0.01 to 1 Ω/□, more preferably from 0.01 to 0.5 Ω/□ expressed in surface resistivity. In the invention, the surface resistivity is measured with the use of a 4-pin probe resistivity meter.

The thickness of the conductive layer (B) is preferably from 0.5 to 20 µm, though the invention is not restricted thereto. When the conductive layer (B) is too thin, only an insufficient conductivity can be obtained. On the other hand, an excessive thickness thereof brings about an increase in cost or an increase in weight. Thus, it is preferable that the thickness is from 5 to 15 µm.

Although the pattern of the conductive layer (B) is not particularly restricted, a thinner line width and a wider line interval contribute to an increase in the aperture rate and, in its turn, the light transmittance in the indication part is elevated. It is also favorable that interference fringes (moire) scarcely arise in such a case. When the aperture rate is excessively elevated, however, the conductive layer (B) shows a poor conductivity. Therefore, use can be preferably made of a line width of from 1 to 50 µm and a pitch of from 30 to 500 µm.

To prevent the occurrence of interference fringes (moire) caused by the optical interference with light emitted from display pixels aligned lengthwise and crosswise, it is important that mesh pattern lines in the lattice mesh pattern are located at a certain angle (a bias angle) to the pixel lines. The bias angle may be appropriately selected depending on the pixel pitch and the pitch and line width of the mesh pattern.

Since an electromagnetic wave shielding material (C), wherein a conductive layer (B) formed on one face of a polymer film (A), which has a mesh pattern continuously formed in the machine direction of the polymer film (A), is used in the invention, an arbitrary part in the machine direction can be cut and bonded to glass, which makes it possible to produce a display filter at an extremely high productivity. Since the mesh-like part is continuously formed, an electromagnetic wave shielding material (C) of a single specification can be cut into pieces which have arbitrary widths and are applicable to various kinds of display filters.

The term "machine direction" as used in the invention means the direction along which a material is processed and transported in or on the machine in the course of the production. In the case of a polymer film roll processed by the roll-to-roll system, for example, the direction along which the unwound film is transported in the processing is regarded to as the machine direction.

Figs. 2 and 3 are plan views of a mesh-like electromagnetic wave shielding material observed from the conductive layer (B) side. The mesh shape may be either lattice or honeycomb without particular restriction. The conductive layer (B) is formed continuously on the polymer film (A). The term "continuously" as used herein means that the mesh shape is formed without cutting in the mechanical direction of the polymer film (A). The range of the continuity, i.e., the length (dx) in Figs. 2 and 3 corresponds at least to two display filter sheets. In being used in a 42 in. filter, for example, the length dx is 2 m or longer. More preferably, the length dx corresponds to five display filter sheets. In being used in a 42 in. filter, for example, it is desirable that the length dx is 5 m or longer. The upper limit of the range of the continuity is not particularly restricted and varies depending on the thickness of the polymer film (A) employed and the thickness of the conductive layer (B). In the case where the thickness of the polymer film (A) is 100 µm, the length dx is preferably 2000 m or less.

The electromagnetic wave shielding material (C) thus formed is cut into various sizes and shapes and utilized in display filters. The electromagnetic wave shielding material (C) may be cut into various widths such as 500 mm or 400 mm fitting for filter sizes and then the mesh-like parts are cut in the machine direction to give arbitrary lengths fitting for the filter sizes to thereby produce display filters. Thus, an electromagnetic wave shielding material (C) of a single specification can be used in display filters of arbitrary sizes. The mesh shape in the conductive layer (B) is not always formed on the entire face of the polymer film (A) as in Fig. 2. So long as the mesh shape is continuously formed in the machine direction of the polymer film (A) as, for example, shown in Fig. 3, it is not always necessary that the starting and terminal ends and periphery of the film are mesh-like.

It is necessary that at least one face of the conductive layer (B), i.e., either the polymer film (A) side or the opposite side, has a black or blackish brown color. When the display filter is mounted on a display, the black or blackish brown face is located in the viewer's side so that the contrast and visibility of the display can be improved. In the case of using a face in a metallic color or a white color made of copper, aluminum, nickel, etc., the light reflection on the display face is increased and thus the visible light reflectivity of the display filter is elevated. As a result, the contrast or visibility is lowered or the display filter has a metallic color. Although a brown or blackish brown face contributes to the reduction of the reflection compared with a metallic or white face, a black face is more preferable. It is also favorable that the face, which is to be located in the display side when the display filter is mounted on a display, has a blackish brown or black color, since the back face reflection of the display filter can be reduced thereby.

Examples of the method of imparting a black or blackish brown color to the face of the conductive layer (B) in the polymer film (A) side or in the side opposite to the polymer film (A) include; (a) a method which comprises using a conductive ink; (b) a method which comprises using a blackened metal foil; and (c) a method which comprises laminating a thin metal film, a thin metal oxide film or a metal sulfide film each having a black color. As the conductive ink in the method (a), use can be made of a conductive ink containing carbon black or a black pigment. The blackened metal foil in the method (b) means a metal foil having been surface-roughened in one or both faces or a metal foil having a black layer comprising a black pigment or an oxide or sulfide of copper or chromium, for example, chromium trioxide or nickel sulfide, though the invention is not restricted thereto. The surface of the metal foil may have an antirust layer or the antirust layer may have a black color. It is also preferable to minimize visible irregularities in the black layer provided on the metal foil surface. It is undesirable to form the conductive layer (B) by using a metal foil having serious irregularities, since the display filter thus constructed shows irregular reflection on the filter surface. In the method (c) of laminating a thin metal film, a thin metal film, a thin metal oxide film, a thin metal sulfide film or a mixture thereof each having a black color and comprising chromium, etc. is laminated on the uppermost layer, or the lowermost layer and the uppermost layer to form a single or multiple layers. In each method, it is important that the conductive layer (B) has practically acceptable ability to shield electromagnetic wave even after blackening the surface.

It is preferable in the invention to produce a display filter by bonding the electromagnetic wave shielding material (C), which has the conductive layer (B) formed on one face of the polymer film (A), to a transparent support (F) via a transparent sticky material layer (D1), or bonding it directly to the display panel via the transparent sticky material layer (D1) without using the transparent support (F).

From the viewpoints of mechanical strength, lightness and non-fragileness, it is preferable to use a plastic plate being transparent in the visible light region as the transparent support (F). Specific examples thereof include an acrylic resin such as methyl polymethacrylate (PMMA), a polycarbonate resin and a transparent ABS resin. On the other hand, a glass plate is also appropriately usable form the viewpoint of the high heat stability, i.e., suffering from little deformation due to heating. In the case of using a glass plate, it is preferable to employ a hardened glass plate, which has been subjected to a chemical hardening processing or an air-cooling hardening processing so as to impart mechanical strength, or a heat-treated glass plate. It is also possible to conduct colored (for example, black) frame printing in the part serving as the periphery of the optical filter.

To the display filter thus obtained, another functional film (E) may be bonded. By bonding the functional film (E), it is possible to impart the function carried by the functional film (E) such as hard coating properties, antireflective properties, antiglare properties, antistatic properties, antifouling properties, ultraviolet ray blocking properties, near infrared ray blocking properties and so on to the display filter. The functional film (E) may be bonded in the conductive layer (B) side of electromagnetic wave shielding material (C) via a transparent sticky material layer (D2). Alternatively, it is possible that a transparent support (F) is bonded in the polymer film (A) side of the electromagnetic wave shielding material (C) via a transparent sticky material layer (D1) and then the functional film (E) is bonded to face of the transparent support (F) opposite to the electromagnetic wave shielding material (C) via a transparent sticky material layer (D3). Examples of the constitution of the display filter according to the invention are as follows: (E)/(D2)/(B)/(A)/(D1)/(F), (B)/(A)/(D1)/(F)/(D3)/(E), (E)/(D2)/(B)/(A)/(D1)/(F)/(D3)/(E) and so on.

The functional film (E) is a transparent polymer film having one or more functions selected from among hard coating properties, antireflective properties, antiglare properties, antistatic properties, antifouling properties, ultraviolet ray blocking properties, near infrared ray blocking properties and so on. It may be a film consisting of one or more layers having the above function(s) or a film containing substance(s) having the individual function(s). In the case of using a plurality of the functional films (E) in a single display, use can be made of films having different functions. When mounted on a display, for example, a functional film (E) used in the face located in the viewer's side of the display filter may be different from another functional film (E) used in the face located in the display side. The polymer film to be used in the functional film (E) may be an arbitrary one, so long as it is transparent in the visible wavelength region. Specific examples thereof include polyethylene terephthalate, polyether sulfone, polycarbonate and so on, though the invention is not restricted thereto.

In a display, extraneous images caused by the reflection of a lighting apparatus, etc. interferes the viewing of the display screen. Thus, use is preferably made of a functional film (E) having either antireflective (AR) properties of preventing the reflection of outside light, antiglare (AG) properties of preventing mirror reflection or antireflective and antiglare (ARAG) properties satisfying both of these requirements. A low visible light reflectivity of a display filter surface contributes not only to the prevention of the reflection of outside light but also to an improvement in contrast and so on.

To impart a sufficient scratch resistance to the display filter, it is favorable that the functional film (E) has hard coat properties. Further, dusts and debris frequently stick to a display filter due to electrostatic charge. When being in contact with the human body, a display filter sometimes causes an electrical shock due to discharge. Therefore, it is preferable that the functional film (E) has conductivity for imparting antistatic properties. It is favorable that the hard coat film, the antireflective film or the antiglare film is provided with a conductive film or contains conductive micrograins.

It is preferable that the surface of the functional film (E) has antifouling properties, since fouling with finger prints or the like can be prevented and foulings, if any, can be easily removed thereby. It is favorable to employ an antifouling layer in the antireflective film, since an antifouling antireflective film can be thus obtained.

In the present invention, the functional film (E) is bonded to a display filter with the use of an arbitrary transparent sticky material or adhesive. In the invention, a visible light transmitting sticky material or adhesive is called a transparent sticky material. As the transparent sticky material, use can be preferably made of a pressure-sensitive adhesive in the form of a sheet. It is also possible to use a liquid type one to be coated. Moreover, use can be made of a liquid type adhesive which hardens by allowing to stand at room temperature or heating. It is favorable that the face of the functional film (E) on which the sticky material layer is to be formed is preliminarily subjected to an adhesion-facilitating treatment such as coating with an adhesion accelerator or corona discharge so as to improve the wetting characteristics.

Since a plasma display generates strong near infrared rays, these near infrared rays should be reduced to such an extent as causing no problem in practice. Thus, a display filter to be used in a plasma display should have a transmission color of neutral gray or blue gray. This is because it is necessary to maintain or improve the light emission characteristics and contrast of the plasma display and a white color with a somewhat higher color temperature than the standard white color is preferred in some cases. It is said that a color plasma display has only insufficient color reproducibility. It is therefore preferable to selectively lower unnecessary light emission from a fluorescent body or discharged gas causing the above problem by the display filter.

These optical characteristics can be controlled by using a dye in the display filter. Namely, near infrared rays can be cut by using a near infrared absorber while unnecessary light emission can be reduced by using a dye capable of selectively absorbing the unnecessary light emission, thereby achieving desired optical characteristics. It is also possible to achieve a favorable color tone of the display filter by using a dye having an appropriate absorption within the visible region.

A dye may be contained in the display filter by using one or more methods selected from: (a) using a polymer film or a resin plate produced by kneading one or more kinds of dyes with a transparent resin; (b) using a polymer film or a resin plate produced by the casting method by dispersing or dissolving one or more kinds of dyes in a thick resin solution comprising a resin monomer/an organic solvent; (c) using a polymer film or a resin plate coated with a coating produced by adding one or more kinds of dyes and a resin binder to an organic solvent; and (d) using a sticky material containing one or more kinds of dyes; though the invention is not restricted thereto. The term "contained" as used herein means not only being contained in a base, a layer such as a coating film or a sticky material but also being coated on the surface of a base or a layer. Multiple kinds of dyes may be contained.

In the invention, two kinds or more dyes having different absorption wavelengths may be contained in a single medium or coating film. It is also possible to provide two or more dye-containing media or coating films. The dye may be contained in either of the polymer film (A), the adhesive layer, the sticky material layer, the functional film (E) or the transparent support (F).

In an instrument with a need for preventing the leakage of electromagnetic wave generated therefrom, it is required to block the electromagnetic wave by forming a metal layer in the case of the instrument or using a conductive material as the case. When a transparent indication part is needed as in a display, a window-shaped electromagnetic wave shielding filter having a light transmitting conductive layer, such as the display filter of the invention, is provided. Electromagnetic wave is absorbed by the conductive layer and then induces electrical charge. The charge thus generated oscillates electromagnetic wave by using the conductive substance as an antenna. Unless the charge is quickly cut off by earthing, therefore, there arises a risk of the leakage of the electromagnetic wave. Therefore, the display filter should be in electrical contact with the earthing part of the display body. In the case of forming another layer on the conductive layer (B) of the electromagnetic wave shielding material, the conductive layer (B) is not entirely coated with the other layer but a conductive connection part allowing conduction to the outside should be left. The constitution wherein the functional film (E) is bonded to the conductive layer (B) via the transparent sticky material layer (D2) as described above corresponds to this case. Although the conductive connection part is not particularly restricted in shape, it is necessary that there is no gap allowing the leakage of electromagnetic wave between the display filter and the display body. It is therefore adequate that the conductive connection part is continuously formed in the periphery of the conductive layer (B). Namely, it is preferable that a frame-like conductive connection part is provided excluding the center serving as the indication part of the display. However, the invention is not particularly restricted thereto and a discontinuous conductive connection part may be employed so long as the leakage of the electromagnetic wave can be prevented. For example, use can be made of the end sections of two facing sides of the display filter as the conductive connection parts.

The conductive connection part may be the conductive part of the geometric pattern in the conductive layer (B). However, it is sometimes preferable for improving the electrical contact with the earthing part of the display to form an electrode on the conductive layer (B) serving as the conductive connection part. Although the electrode is not particularly restricted in shape, it is appropriate to form it so as to entirely cover the conductive connection part.

From the viewpoints of conductivity, corrosion resistance and adhesiveness to the conductive layer (B), examples of the material to be used for the electrode include conductive coating materials or pastes of metals such as silver, copper, nickel, aluminum, chromium, iron, zinc and carbon, which may be used either singly or as an alloy of two or more kinds thereof, mixtures of such metals (either singly or as an alloy) with a synthetic resin, and mixtures comprising borosilicate glass with such metals (either singly or as an alloy). To print and coat such a conductive coating material or paste, use can be made of a publicly known method. It is preferable that the coating or paste to be used has a black color. In the case where the electrode thus formed has a black color, it is usable as a substitute for a black frame print, which has been employed for distinguishing an indication part from a non-indication part in the display, and thus the filter can be produced at a lowered cost.

As the coating or paste to be used this case, use can be made of a combination of an alloy with a resin as described above. It is appropriate to use a coating or a paste comprising carbon alone with a resin, or a black coating or paste prepared by adding carbon micrograins to a highly conductive metal coating or paste comprising silver, copper, etc. Moreover, a marketed conductive tape is appropriately usable. As a conductive tape, use can be made of either a tape having conductivity in both faces or a single-side adhesive type using a conductive adhesive of the carbon dispersion type. The thickness of the electrode is several µm to several mm, though the invention is not restricted thereto.

It is preferable that the visible light transmittance of the display filter is from 30 to 85%, more preferably form 35 to 70%. When the visible light transmittance is less than 30%, the luminance of the display screen is excessively lowered and the visibility is worsened. In the case where the visible light transmittance of the display filter is too high, the contrast of the display cannot be improved. The visible light transmittance in the present invention is calculated in accordance with JIS(R-3106) based on the wavelength-dependency of transmittance in the visible light region.

### Examples

Next, the present invention will be described in greater detail by referring to the following Examples of the invention. The materials, amounts, ratios, treatments, treating procedures and so on shown in the following Examples can be optionally altered within the scope of the present invention. That is to say, the scope of the invention should not be construed as being restricted to the following Examples.

### (Example 1-1)

### (Silver halide photosensitive material)

An emulsion containing 10.0 g of gelatin to 60 g of Ag in an aqueous medium and containing silver iodobromide grains (1=0.2% by mol, Br=40% by mol) having a sphere-corresponding average diameter of 0.1 µm was prepared.

In this emulsion, K₃Rh₂Br₉ and K₂IrCl₆ were added to give a concentration of 10⁻⁷ mol/mol of Ag thereby doping the silver bromide grains with Rh ions and Ir ions. To this emulsion, Na₂PdCl₄ was added and a gold-sulfur sensitization was conducted with the use of chloroauric acid and sodium thiosulfate. Next, the emulsion was coated together with a gelatin film hardening agent on the polyethylene terephthalate (PET) to give a silver coating amount of 1 g/m². In this step, the Ag/gelatin volume ratio was adjusted to 1/2.

The emulsion was coated on a part (25 cm in width, 20 m in length) of a PET support having a width of 30 cm. Then the both edges (3 cm) of the support were cut off while remaining the center (24 cm) of the coated part to give a rolled silver halide photosensitive material.

### (Exposure)

The silver halide photosensitive material was exposed using a continuous exposure apparatus described in the mode for carrying out the invention in JP-A-2004-1244 wherein exposure heads with the use of a DMD (digital mirror device) were aligned in a width of 25 cm, the exposure heads and an exposure stage were provided in a curved state for focusing images of laser beams onto the photosensitive layer, a photosensitive material-feeding unit and a winding unit were attached, and a deflection having a buffering action was given so as to prevent the effect of a change in the speeds of winding and feeding units on the speed of the exposure part. The exposure wavelength was 400 nm, the beam pattern was almost square in 12 µm, and the laser light source output was 100 µJ.

The exposure was conducted to give a 45° lattice pattern of 12 µm pixels at intervals of 300 µm pitch having a width of 24 cm and a length of 10 m continuously.

The exposure head as described herein is an exposure head whereby an exposure face is exposed with multiple light beams, which comprises: an irradiation unit emitting light beams; a spatial modulation element for modulating the light beams emitted by the irradiation unit, including a plurality of pixel portions which change light modulation states in accordance with respective control signals, the pixel portions being arranged in a two-dimensional pattern on the support; an optical system for focusing images of the light beams having been modulated by the respective pixel portions as beam spots onto the exposure surface; and an aperture array which is located on the optical path of the optical system and has multiple apertures having different opening areas and opening shapes for shaping the beam spots and by which the beam spots passing through the apertures having different opening areas and opening shapes cause multiple exposure or overlap exposure, characterized by changing and controlling the exposure ratios of the individual beam spots that have passed the apertures having different opening areas and opening shapes and focused on the exposure face.

Owing to the above-described constitution, light beams emitted from the irradiation unit are modulated in the individual pixel portions in the spatial modulation element. Then, the individual light beams having been modulated in the exposure state in the individual pixel portions pass through apertures and the beam spots are shaped by partly shielding the light beams followed by the irradiation onto the exposure face. During this exposure processing, the exposure ratios of the individual beam spots are changed from aperture to aperture having different opening areas and opening shapes. Thus, the exposure ratios can be changed among the beam spots having passed the apertures having different opening areas and opening shapes so that the exposure doses of the individual beam spots, which have different areas and shapes when focused on the exposure face in multiple or overlap exposure, can be altered to achieve the same functions and effects as changing the opening areas and the opening shapes of the apertures. As a result, it becomes possible to conduct the exposure processing (exposure recording) approximately in accordance with appropriate spot sizes (beam spot areas) and spot shapes of the beam spots on the exposure face which vary depending on various conditions such as the shape and diagram of the exposure pattern and the properties of the photosensitive material. Thus, the shape and diagram of the exposure pattern can be appropriately formed by using this exposure head. It is also possible to change the opening areas and opening shapes of the apertures without replacing the aperture array and it is unnecessary to transport the aperture array, etc. Owing to these characteristics, the constitution can be simplified and the beam spot shapes can be immediately changed so as to achieve appropriate beam spot shapes which vary depending on various conditions such as the shape and diagram of the exposure pattern and the properties of the photosensitive material. Since the complicated and troublesome operation for taking off the aperture array and replacing by another one can be omitted, the working efficiency can be improved.

### (Development processing)

### Composition of developing solution (1 L)

| | |
|---|---|
| hydroquinone | 20 g |
| sodium sulfite | 50 g |
| potassium carbonate | 40 g |
| ethylenediamine tetraacetate | 2 g |
| potassium bromide | 3 g |
| polyethylene glycol 2000 | 1 g |
| potassium hydroxide | 4 g |
| pH | adjusted to 10.3 |

### Composition of fixing solution (1 L)

| | |
|---|---|
| ammonium thiosulfate (75% solution) | 300 ml |
| ammonium sulfite monohydrate | 25 g |
| 1,3-diaminopropane tetraacetate | 8 g |
| acetic acid | 5 g |
| aqueous ammonia (27%) | 1 g |
| pH | adjusted to 6.2 |

Using the solutions as listed above, a development processing was conducted by using an automatic development machine FG-710 PTS (manufactured by Fuji Film Co.) under the following development conditions; development: 30 seconds at 35°C, fixation:; 23 seconds at 34°C, water washing: 20 seconds under running water (5 L/min).

As a running processing, 100 m²/day of the photosensitive material was developed for 3 days while supplying 500 ml/m² of a developer replenisher and 640 ml/m² of the fixing solution.

Further, an electroless copper plating was conducted at 45°C by using a plating solution (an electroless copper plating solution containing 0.06 mol/L of copper sulfate, 0.22 mol/L of formalin, 0.12 mol/L of triethanolamine, 100 ppm of polyethylene glycol, 50 ppm of potassium ferrocyanide and 20 ppm of α,α'-bipyridine, pH=12.5) followed by an oxidation processing with an aqueous solution containing 10 ppm of Fe(III) ion. Thus, Sample A of the invention was obtained.

### (Comparative Example 1-1)

For comparison, an exposure processing was conducted 10 times by using a Fresnel printer (Model FL-S; manufactured by Ushio Lighting Inc.) and a mask of 24 cm in width and 1 m in length which was displaced by 1 m portions. During the exposure processing repeated 10 times, exact positioning was made by marking the silver halide photosensitive material at intervals of 1 m. After the completion of the exposure, the photosensitive material was developed and plated as in Sample A to give Sample B for comparison. In this step, it was confirmed that the copper pattern obtained after the plating processing had a line width of 12 µm and a 300 µ pitch.

### [Evaluation]

### (Measurement of surface resistivity)

To evaluate the evenness in surface resistivity, the surface resistivities of Samples A and B were measured at arbitrary 200 sites by using LORESTA GP (Model MCP-T610; manufactured by DIA INSTRUMENTS Co., Ltd.) inline 4-pin probe type (ASP).

### (Evaluation results)

As Table 1 shows, Sample A of the invention showed even surface resistivity, while measurement could not made at 7 sites in Sample B, indicating that the evenness was low.

**Table 1**

| | Average surface resistivity at 200 sites | No. of sites where surface resistivity could not measured (OV.LD. indication) |
|---|---|---|
| Sample A | 0.19 Ω/□ | 0 |
| Sample B | 0.19 Ω/□ (excluding OVLD) | 7 |

### (Example 1-2)

As a typical example of "(3) Mesh obtained by etching process using photolithographic technique" cited in the above Background Art, a metal mesh disclosed in JP-A-2003-46293 was manufactured.

When compared as in Example 1-1, it was clarified that an even surface resistivity was obtained by forming the continuous pattern according to the present invention, which indicates the effectiveness of the invention.

### (Example 1-3)

Sample C was produced as in Sample A in Example 1-1 but the continuous pattern was formed by conducting the exposure with the use of a rotational polygon mirror scanning laser exposure which was located so as to conduct scanning at angles of 45° and -45° to the transport direction of the silver halide photosensitive material. When Sample C was compared with Sample B, the same results as in Example 1-1 were obtained.

### (Example 1-4)

The electromagnetic wave shielding film produced in the above Example was provided on a biaxially stretched polyethylene terephthalate (hereinafter PET) film (thickness: 100 µm) and then treated with a copper blackening solution to thereby blacken the copper face. As the blackening solution, use was made of a commercially available product COPPER BLACK (manufactured by ISOLATE KAGAKU KENKYUSHO). In the PET face side, a protective film having a total thickness of 28 µm (HT-25; manufactured by PANAC KOGYO K.K.) was bonded by using a laminator roller.

In the electromagnetic wave shielding film (metal mesh) side, a protective film comprising an acrylic sticky material layer on a polyethylene film and having a total thickness of 65 µm (trade name: SANITECT Y-26F; manufactured by SUN A KAKEN Co.) was bonded by using a laminator roller.

Using the PET face as the bonding face, it was bonded to a glass plate (thickness: 2.5 mm, outer size 950 mm x 550 mm) via a transparent acrylic sticky material.

After cutting off the outer periphery (20 mm), an antireflective near infrared-absorbing film of 100 µm in thickness (trade name: CLEARAS AR/NIR; manufactured by SUMITOMO OSAKA CEMENT, Co., Ltd.) comprising a PET film, an antireflective layer and a near infrared ray absorber-containing layer was bonded to the conductive mesh layer located inside via an acrylic light transmitting sticky material having 25 µm in thickness. The acrylic light transmitting sticky material layer contained toning dyes (PS-Red-G and PS-Violet-RC; manufactured by MITSUI CHEMICALS, Inc.) controlling the transmission characteristics of a display filter. On the main face of the glass plate opposite thereto, an antireflective film (trade name: REALOOK 8201; manufactured by NOF Co.) was bonded via a sticky material to give a display filter.

Because of having been produced by using the electromagnetic wave shielding film provided with the protective film, the display filter thus obtained suffered from little scuff marks or defects in the metal mesh. Since the metal mesh had a black color, the display image showed no metallic color. The display filter had such electromagnetic wave shielding properties and ability to block near infrared rays (transmission at 300 to 800 nm: 15% or less) as causing no problem in practice. Owing to the antireflective layers provided on both faces, it showed an excellent visibility. Because of containing the dyes, moreover, it had a color-modulating function, which makes it appropriately usable as a display filter for a plasma display, etc.

### (Example 1-5)

As a typical example of "(3) Mesh obtained by etching process using photolithographic technique" cited in the above Background Art, a metal mesh was manufactured in accordance with Example 1 of manufacturing an electromagnetic wave shielding material disclosed in JP-A-2001-53488 but forming no frame part but drawing a thin line lattice pattern inclining at 45° to the major side of the electromagnetic wave shielding material to the part serving as the frame.

By using a sample for evaluation having a mesh pattern of 25 cm in width and 10 m in length thus obtained, evaluation was made as in Example 1-1. As a result, it was clarified that an even surface resistivity was obtained by forming the continuous pattern according to the present invention, which indicates the effectiveness of the invention.

### (Example 2-1)

A biaxially stretched polyethylene terephthalate (PET) film of 600 mm in width, 200 m in length and 100 µm in thickness (A4300; manufactured by TOYOBO Co., Ltd.) was coated with an emulsion comprising a silver halide and gelatin to give a coating dose of silver of 1 g/m². Then, it was continuously mesh-like patterned by the roll-to-roll system with semiconductor laser scanning followed by a development processing with the use of a developing solution (CN-16; manufactured by FUJI FILM Co.) and a fixing solution (trade name: SUPER FIJIX; manufactured by FUJI FILM Co.). After removing an unexposed part, it was washed with purified water and then subjected to an electroless copper plating with the use of a plating solution containing copper sulfate and triethanolamine. Thus, a film (hereinafter referred to as a mesh film) having a conductive layer, in which a conductive lattice pattern having a thickness of 10 µm, a line width of 10 µm, a pitch of 300 µm and a bias angle of 45° had been formed, was obtained. Subsequently, the mesh film was electroplated on the conductive layer with a solution containing nickel sulfate to give a mesh film having been blackened in the conductive layer surface. The surface resistivity of the conductive layer measured by using a resistometer of the inline 4-pin probe type (LORESTA EP (manufactured by MITSUBISHI CHEMICAL Co.) was 0.3 Ω/□.

Next, an acrylic light transmitting sticky material containing toning dyes (PS-Red-G and PS-Violet-RC; manufactured by MITSUI CHEMICALS, Inc.) controlling the transmission characteristics of a display filter was continuously coated on the release layer of a release film consisting of a PET film and a silicone release layer to give a sticky material containing the dyes. The sticky material containing the dyes of the release film thus obtained was bonded to the face of the mesh film having no conductive layer. Further, the both edges of the film in the width direction were cut to give a mesh film being 580 mm in width and having the sticky material containing the dyes.

On one face of a 100 µm PET film (TEIJIN TETRON FILM HB TYPE; manufactured by TEIJIN DUPONT FILMS), an acrylic hard coat layer and an antireflective layer being composed of two layers including a fluororesin layer and an indium oxygen-containing resin layer and having antifouling and antistatic properties were successively formed by the wet coating method. On the other face of the film, a near infrared absorbent layer comprising a dimonium- and phthalocyanine-based near infrared absorber and an acrylic binder resin was formed. Thus, a near infrared absorbing film provided with an antireflective layer having UV blocking properties, antifouling properties, antistatic properties and hard coat properties (hereinafter an AR/NIRA film) was manufactured.

An acrylic light transmitting sticky material layer was continuously coated on the release layer of a release film and continuously bonded to the near infrared absorbing layer of the AR/NIRA film. Further, the both edges of the film in the width direction were cut to give an AR/NIRA film being 570 mm in width and having the sticky material.

To a glass plate (thickness: 2.5 mm, outer size: 984 mm in length x 584 mm in width) having a strength elevated by the air-cooling hardening method, the mesh film was bonded via the sticky material containing the dyes while peeling off the release film in such a manner that the center in the width direction of film agreed with the center of the glass. The mesh-like part of the mesh film was cut so as to meet with the glass size.

To the face of the glass plate having the mesh film bonded thereto, the AR/NIRA film being 570 mm in width and having the sticky material was bonded starting from a part 7 mm inside from the edge via the sticky material while peeling off the release film and then the AR/NIRA film was cut off. The AR/NIRA film was bonded so that an AR/NIRA film-free part 7 mm in width remained in the periphery of the glass.

The AR/NIRA film-free peripheral part 7 mm in width as described above, wherein the mesh film and the glass plate were exposed, was subjected to screen printing with a silver paste (MSP-600F; manufactured by MITSUI CHEMICALS, Inc.). In this step, use was made of a silver paste having a viscosity adjusted to about 200 Poise (about 200 (Pas)) by diluting with butyl cellosolve acetate. After printing, it was dried at room temperature to thereby form an electrode having a thickness of 10 µm.

The laminate thus obtained was put into an autoclave container and pressurized under the conditions of an initial temperature of 40°C, an initial pressure of 0.8 MPa, a pressure-rising time of 30 minutes and a retention time of 30 minutes. Thus, a display filter according to the invention was manufactured. Fig. 4 is a sectional view showing the constitution of this display filter.

### (Example 2-2)

A display filter was manufactured as in Example 2-1 excluding the following points.

The width of the AR/NIRA film having the sticky material was 580 mm and the AR/NIRA film was bonded not to the mesh film but to the glass face having no mesh film followed by cutting to meet with the glass size.

The electrode was printed on the glass face in the side having the mesh film and the part where the mesh film and the glass plate were exposed was located in the periphery of 12 mm in width along all of the four sides.

Fig. 5 is a sectional view showing the constitution of this display filter.

### (Example 2-3)

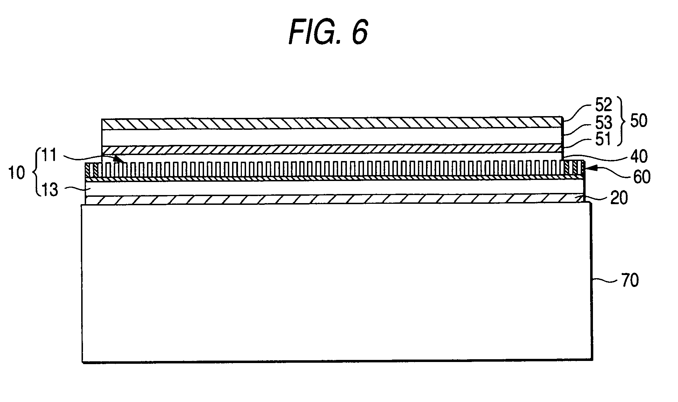

The AR/NIRA film of 570 mm in width having the sticky material as described in Example 2-1 was cut into a length of 970 mm. The mesh-like part of the mesh film having the dye-containing sticky material manufactured in Example 2-1 was cut to give a length of 980 mm. The release film of the AR/NIRA film having the sticky material was peeled off and the AR/NIRA film was bonded to the conductive layer side of the mesh film so that an AR/NIRA film-free part was left in 5 mm width in the periphery of the conductive part of the mesh film. The AR/NIRA film-free conductive layer part in the periphery of the mesh film was screen printed with the silver paste as in Example 2-1, put into an autoclave container, and pressurized under the same conditions as in Example 2-1. After peeling off the release film of the mesh film having the dye-containing sticky material, the laminate thus obtained was bonded to a plasma display panel to give a filter-integrated plasma display panel. Fig. 6 is a sectional view showing the constitution of this filter-integrated display filter.

### (Example 2-4)

A biaxially stretched PET film of 600 mm in width, 200 m in length and 100 µm in thickness (A4300; manufactured by TOYOBO Co., Ltd.) and a blackened copper foil of 10 µm in thickness were continuously bonded together by the dry laminate method with the use of a two-pack hardening type polyurethane-based transparent adhesive (TAKELAC A310 (major component)/TAKENATE 10 (hardening agent); manufactured by TAKEDA PHARMACEUTICAL Co., Ltd.) in such a manner that the blackened face served as the bond face. Thus, a laminate film roll having a total thickness of 115 µm was obtained.

To the copper foil side of the laminate film roll as described above, casein was continuously coated in a pattern as a photosensitive resist by the gravure roll printing method. After drying, it was hardened under an UV lamp. After hardening the resist film and baking at 100°C, a non-resist part was etched with a ferric chloride solution and washed with water. Then, the resist was peeled off with an alkali solution to give a film having a conductive layer on which a conductive lattice pattern having a thickness of 10 µm, a line width of 10 µm, a pitch of 300 µm and a bias angle of 45° had been formed, was obtained. Subsequently, the mesh film was electroplated on the conductive layer with a solution containing nickel sulfate to give a mesh film having been blackened in the conductive layer surface. The surface resistivity of the conductive layer measured by using a resistometer of the inline 4-pin probe type (LORESTA EP (manufactured by MITSUBISHI CHEMICAL Co.) was 0.1 Ω/□.

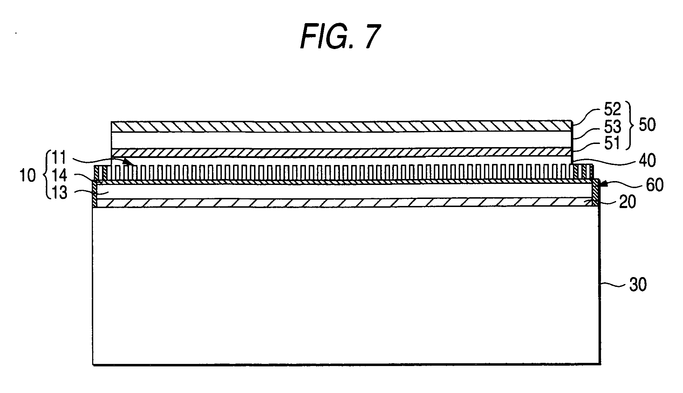

A display filter was manufactured as in Example 2-1 but substituting the mesh film employed in Example 2-1 by the mesh film as described above. Fig. 7 is a sectional view showing the constitution of this display filter.

The display filters obtained in Examples 2-1, 2-2, 2-3 and 2-4 as described above showed practically acceptable electromagnetic wave shielding properties and near infrared blocking ability, suffered from little electrostatic sticking of dusts and debris owing to the antireflective layer and the hard coat layer having antifouling and antistatic effects, and were excellent in antifouling properties, scratch resistance and visibility. Owing to the ultraviolet blocking layer, furthermore, these display filters were free from deterioration in dyes caused by sunlight and showed excellent weatherability.

Although the present invention has been described in detail by referring specific embodiments thereof, it is obvious for those skilled in the art that various changes and modifications can be made without departing from the spirit and scope of the invention.

The present application is based on Japanese Patent Application filed on February, 15, 2005 (Japanese Patent Application No. 2005-038194) and Japanese Patent Application filed on February, 22, 2005 (Japanese Patent Application No. 2005-046247) and the contents thereof are incorporated herein for the sake of reference.

### Industrial Applicability

The present invention is usable as a light transmitting conductive film. In particular, it is usable as an electromagnetic wave shielding material which is capable of shielding electromagnetic wave generated from the front face of a display such as a cathodic ray tube (CRT), a plasma display panel (PDP), a liquid crystal display, an electroluminescence (EL) display or a field emission display (FED), a microwave oven, an electronic device, a printed line board and so on and has a light transmittance.

## Claims

1. A light transmitting conductive film formed by patterning a conductive metal part and a visible light transmitting part on a transparent support,
wherein the conductive metal part is made up of mesh-forming thin lines of from 1 µm to 40 µm in size and the mesh pattern continues for 3 m or longer.

2. A light transmitting conductive film formed by patterning a developed silver part and a visible light transmitting part on a transparent support, and making the developed silver part to carry a conductive metal thereon to form a conductive metal part,
wherein the conductive metal part is in a mesh shape made up of thin lines of from 1 µm to 30 µm in size and the mesh pattern continues for 3 m or longer.

3. The light transmitting conductive film according to claim 1,
wherein the transparent support is a film which has a flexibility and is 2 cm or more in width, 3 m or more in length and 200 µm or less in thickness.

4. The light transmitting conductive film according to claim 1,
wherein the mesh pattern is a pattern made up of straight thin lines, which are being arranged substantially in parallel, intersecting with each other.

5. The light transmitting conductive film according to claim 1,
wherein the patterning is conducted by scan-exposing the transparent support with a laser light beam while transporting the transparent support on a curved exposure stage.

6. The light transmitting conductive film according to claim 5,
wherein a main scanning direction of the light beam is perpendicular to a support transport direction.

7. The light transmitting conductive film according to claim 5,
wherein a light intensity of the light beam has two or more values including state of being substantially zero.

8. The light transmitting conductive film according to claim 1,
wherein the patterning is conducted by using an exposure head intersecting with a support transport direction, and
the exposure head comprises: an irradiation unit for emitting a light beam; a spatial modulation element for modulating the light beam emitted by the irradiation unit, including a plurality of pixel portions which change light modulation states in accordance with respective control signals, the pixel portions being arranged in a two-dimensional pattern on the support; a controller for controlling respective pixel portions, which are in a smaller number than the sum of the pixel portions arranged on the support, in accordance with the control signals formed on the basis of exposure data; and an optical system for focusing images of the light beam having been modulated by the respective pixel portions onto an exposure surface.

9. The light transmitting conductive film according to claim 5,
wherein the scanning is conducted while inclining the light beam at an angle of 30° to 60° to the transport direction.

10. The light transmitting conductive film according to claim 9,
wherein a light intensity of the light beam has only one value in the course of the patterning.

11. The light transmitting conductive film according to claim 5,
wherein a wavelength of the light beam is 420 nm or less.

12. The light transmitting conductive film according to claim 5,
wherein a wavelength of the light beam is 600 nm or more.

13. The light transmitting conductive film according to claim 5,
wherein an energy of the light beam is 1 mJ/cm² or less.

14. The light transmitting conductive film according to claim 2,
wherein the developed silver part is formed by developing a silver halide.

15. The light transmitting conductive film according to claim 1,
wherein the conductive metal part is formed by etching a copper foil.

16. A light transmitting electromagnetic wave shielding film, which comprises the light transmitting conductive film according to claim 1.

17. The light transmitting electromagnetic wave shielding film according to claim 16, which has an adhesive layer.

18. The light transmitting electromagnetic wave shielding film according to claim 16, which has a peelable protective film.

19. The light transmitting electromagnetic wave shielding film according to claim 16,
wherein a part having a black color amounts to 20% or more of a total surface area of the conductive patterned face.

20. The light transmitting electromagnetic wave shielding film according to claim 16, which has a functional transparent layer having one or more functions selected from the group consisting of infrared ray-shielding properties, hard coating properties, antireflective properties, antiglare properties, antistatic properties, antifouling properties, ultraviolet ray protection properties, gas barrier properties and display panel-breakage prevention properties.

21. The light transmitting electromagnetic wave shielding film according to claim 16, which has infrared ray-shielding properties.

22. An optical filter, which has the light transmitting electromagnetic wave shielding film according to claim 16.

23. A display filter, which uses the light transmitting conductive film according to claim 1.

24. The display filter according to claim 23,
wherein end sections of at least two sides facing each other serve as conductive parts of a geometric pattern.

25. The display filter according to claim 24,
wherein an electrode is formed by using a black conductive coating.

26. A method of producing a display filter by using the light transmitting conductive film according to claim 1, the method comprises the step of bonding to a film having a sticky material layer having a width narrower than the light transmitting conductive film.

27. The method of producing a display filter according to claim 26, which comprises the step of bonding the light transmitting conductive film having been bonded to the film having a sticky material layer to a substrate having a width wider than the light transmitting conductive film.

28. The method of producing a display filter according to claim 26, which comprises the step of bonding the light transmitting conductive film having been bonded to the film having a sticky material layer to a substrate,
wherein the bonding is conducted so that a center in the width direction of the light transmitting conductive film agrees with a center in the width direction of the substrate.

29. The method of producing a display filter according to claim 27 or 28,
wherein a functional film is bonded to the opposite side of the substrate to the light transmitting conductive film.

30. The method of producing a display filter according to claim 29,
wherein the functional film has a width narrower than the light transmitting conductive film.

31. A method of producing a light transmitting conductive film, which comprises scan-exposing a transparent support with a laser beam while transporting the transparent support on a curved exposure stage; and thus
forming a mesh pattern comprising: a conductive metal part made up of mesh-forming thin lines of from 1 µm to 40 µm in size; and a visible light transmitting part, and continuing for 3 m or longer.

32. The method of producing a light transmitting conductive film according to claim 31,
wherein the conductive metal part is a developed silver part.

33. The method of producing a light transmitting conductive film according to claim 32,
wherein the conductive metal part is formed by making the developed silver part to carry a conductive metal thereon.

34. The method of producing a light transmitting conductive film according to claim 32,
wherein the developed silver part is formed by developing a silver halide.

35. The method of producing a light transmitting conductive film according to claim 31,
wherein the conductive metal part is formed by etching a copper foil.

36. The method of producing a light transmitting conductive film according to claim 31,
wherein the exposure is conducted by using an exposure head a main scanning direction of the light beam of which intersects with a support transport direction.

37. The method of producing a light transmitting conductive film according to claim 31,
wherein scanning is conducted while inclining the light beam at an angle of 30° to 60° to a transport direction.

38. The method of producing a light transmitting conductive film according to claim 31,
wherein a light intensity of the light beam has only one value in the course of the patterning.

39. The method of producing a light transmitting conductive film according to claim 31,
wherein a wavelength of the light beam is 420 nm or less.

40. The method of producing a light transmitting conductive film according to claim 31,
wherein a wavelength of the light beam is 600 nm or more.

41. The method of producing a light transmitting conductive film according to claim 31,
wherein an energy of the light beam is 1 mJ/cm² or less.

42. A method of producing a display filter, wherein end sections of at least two sides facing each other serve as conductive parts of a geometric pattern, with using an electromagnetic wave shielding material (C) wherein a conductive layer (B) having the conductive parts of the geometric pattern is formed on one face of a polymer film (A),
wherein the conductive parts of the geometric pattern is continuously formed in a machine direction of the polymer film (A), the conductive parts of the geometric pattern is in a mesh shape having a line width of 1 to 50 µm and intervals of 30 to 500 µm, and a surface resistivity of the conductive layer (B) is 0.01 to 1 Ω/□, and
wherein the method comprises at least the step of cutting the conductive parts of the geometric pattern.

43. The method of producing a display filter according to claim 42,
wherein the electromagnetic wave shielding material (C) comprises a conductive layer (B) wherein the conductive parts are formed by forming a geometric pattern by using a conductive substance (B1) on one face of the polymer film (A) and attaching a conductive substance (B2) on the geometric pattern.

44. The method of producing a display filter according to claim 42,
wherein the electromagnetic wave shielding material (C) comprises a conductive layer (B) wherein the conductive parts of the geometric pattern are formed by bonding the polymer film (A) to a metal foil (B4) via an adhesive layer (B3) and then processing the metal foil (B4).

45. The method of producing a display filter according to claim 42,
wherein at least one face of the conductive layer (B) has a black or blackish brown color.

46. A display filter, which is obtained by the production method according to claim 42.

47. The display filter according to claim 46, which is to be used in a plasma display panel.

48. An electromagnetic wave shielding material to be used in producing the display filter according to claim 42, which is an electromagnetic wave shielding material (C) wherein a conductive layer (B) having conductive parts of a geometric pattern is formed on one face of a polymer film (A),
wherein the conductive parts of the geometric pattern is continuously formed in a machine direction of the polymer film (A), the conductive parts of the geometric pattern is in a mesh shape having a line width of 1 to 50 µm and intervals of 30 to 500 µm, and a surface resistivity of the conductive layer (B) is 0.01 to 1 Ω/□.
